# DEMANDE DE BREVET EUROPEEN

(11) **EP 3 373 303 A1**
(43) Date de publication de la demande: **12.09.2018**
(21) Numéro de dépôt: 18160801.9
(22) Date de dépôt: 08.03.2018
(51) Int. Cl.: G11C 11/401, G11C 11/412, G11C 11/405

(54) **VERROU MEMOIRE TFET SANS RAFRAICHISSEMENT**

(30) Priorité: 10.03.2017 FR 1751955
(71) Demandeur: Commissariat à l'énergie atomique et aux énergies alternatives, 75015 Paris (FR)
(72) Inventeur: GUPTA, Navneet, 38000 GRENOBLE (FR); AMARA, Amara, 92330 SCEAUX (FR); ANGHEL, Costin, 92170 VANVES (FR); MAKOSIEJ, Adam, 38000 GRENOBLE (FR)
(74) Mandataire: Brevalex

(57) **Abrégé**

Verrou mémoire (100) comprenant :
- un TFET (102) ;
- un condensateur (104) ;
- un noeud de stockage (108) formé par la connexion d'une première borne (106) du condensateur à une première électrode du TFET ;
- un circuit de commande configuré pour fournir un premier potentiel électrique sur une seconde borne (110) du condensateur, un deuxième potentiel électrique sur la grille du TFET et un troisième potentiel électrique sur une seconde électrode du TFET, de sorte que :
• lorsque le potentiel stocké est bas, le TFET est polarisé en inverse avec un courant de conduction obtenu par effet tunnel de bande à bande, avec une valeur supérieure à un courant de fuite de condensateur;
• lorsque le potentiel stocké est haut, le TFET est polarisé en inverse avec une valeur de courant de blocage inférieure au courant de fuite du condensateur.

## Description

### DOMAINE TECHNIQUE ET ART ANTERIEUR

La présente invention présente la conception et le fonctionnement de cellules de bit mémoire, ou verrous mémoire, à TFET (pour «Tunnel Field-Effect Transistor » ou transistor à effet de champ tunnel), DRAM (pour « Dynamic Random Access Memory » ou mémoire vive dynamique) et SRAM (pour « Static Random Access Memory » ou mémoire vive statique) sans rafraîchissement. La présente invention est par exemple applicable à tous les cas d'utilisation où une grande capacité de stockage de données est requise. Par exemple, le verrou mémoire de l'invention peut être utilisé dans une mémoire cache pour processeurs embarqués, un traitement multimédia, des coeurs de processeurs de signal numérique (DSP pour « Digital Signal Processor ») ou utilisé en guise de stockage sur puce et/ou hors puce. Le verrou mémoire de l'invention a également trait à la réalisation de systèmes embarqués qui supportent différentes sortes d'applications et comportent un stockage et un traitement de données.

La mise à l'échelle de la technologie CMOS est le facteur clé pour répondre à l'exigence de complexité toujours croissante de conceptions VLSI (pour « Very Large Scale Intégration » ou intégration à très grande échelle) ajoutant toujours plus de puissance de calcul sur une puce. Afin de satisfaire aux contraintes de performances globales tout en réduisant l'échelle des dispositifs, les technologies de mémoire à grand débit sont devenues de plus en plus importantes. Classiquement, le SoC (pour « System-On-Chip » ou système sur puce) repose sur des SRAM afin de répondre à l'écart de débit/de performances entre les unités centrales (CPU pour « Central Processing Unit ») et la mémoire principale (DRAM). Néanmoins, la taille et la consommation de puissance des SRAM sont une préoccupation cruciale avec la croissance rapide des exigences en termes de capacité des mémoires à grande bande passante. Les SRAM sont utilisées comme mémoire cache primaire dans presque toutes les sortes de systèmes de traitement.

La limite de surface due à une médiocre densité matricielle et à une consommation de puissance de fuite des SRAM à grand débit constitue un facteur limitant la réduction de l'empreinte silicium et du coût du système.

Afin de réduire encore la surface et le coût des puces, les DRAM ont été envisagées à titre d'option alternative. Comparées aux SRAM, les DRAM sont meilleures en termes de densité de mémoire et de débit global. Néanmoins, afin de mettre fortement à l'échelle les DRAM, une technologie et un procédé spécifiques sont utilisés, par exemple des transistors verticaux et condensateurs. Cela rend difficile et coûteux l'inclusion de DRAM dans des puces logiques.

Une solution intermédiaire qui a été explorée est l'utilisation de DRAM embarquées (eDRAM) qui sont plus denses que les SRAM et relativement plus faciles à fabriquer avec la technologie CMOS pour une technologie logique numérique, comme le divulgue par exemple le document Brain Ruth et al., « A 22 nm high performance embedded DRAM SoC technology featuring tri-gate transistors and MIMCAP COB », VLSI Technology (VLSIT), 2013 Symposium on. IEEE, 2013. Néanmoins, la structure de la DRAM de type 1T1C devient encore plus difficile à mettre à l'échelle avec la technologie, spécifiquement en raison de difficultés de mise à l'échelle de la capacité. Afin de réduire le préjudice de débit en raison de contraintes de rafraîchissement, des condensateurs de capacité importante ayant néanmoins une faible fuite sont requis. Cela limite la mise à l'échelle des condensateurs des DRAM, car conformément à la feuille de route de l'ITRS (« International Technology Roadmap for Semiconductors ») de 2009 à 2016, un condensateur voit sa capacité augmenter de 20 % alors que la technologie de transistor voit son échelle passer de 52 nm à 22 nm. On utilise diverses techniques, comme la ligne de mots négative et la grande épaisseur d'oxyde de grille des condensateurs, dans les DRAM pour réduire la fuite et augmenter de ce fait le temps de rétention. Toutefois, un EOT (pour « Equivalent oxide thickness » ou épaisseur d'oxyde équivalent) de 0,3 nm est proposé par l'ITRS pour les condensateurs de DRAM, ce qui se traduit par une fuite de condensateur augmentée de façon conséquente.

Dans les eDRAM, la taille de condensateur est réduite aux dépens du temps de rétention afin de minimiser le coût du procédé et l'empreinte silicium. Une autre préoccupation critique, notamment pour les eDRAM, est que la fuite augmente de façon importante aux hautes températures, ce qui est souvent le cas pour les eDRAM en raison de la proximité étroite des blocs de calculs intensifs comme les CPU (pour « Central Processing Unit » ou unité centrale)/GPU (pour « Graphics Processing Unit » ou unité de traitement graphique).

Afin de mettre plus encore les dimensions à l'échelle, des technologies autres que CMOS ont été explorées. Un TFET a été proposé comme solution possible pour réduire les fuites tout en ayant une variabilité d'échelle en tant que MOSFET. Le TFET fonctionne par effet tunnel de bande à bande et donc la pente sous le seuil (S) n'est pas limitée à 60 mV/dec comme cela est le cas du CMOS. Des TFET fabriqués avec une S aussi faible que 30 mV/dec ont déjà été mesurés. Le progrès apporté aux dispositifs TFET a encouragé la recherche sur les circuits à TFET. Un comportement unidirectionnel et des propriétés de résistance différentielle négative (NDR pour « Negative Differential Résistance ») sont très prometteurs pour concevoir des circuits tout en répondant aux questions soulevées par les circuits et architectures CMOS classiques. Dans les documents Gupta Navneet et al., « Ultra-compact SRAM design using TFETs for low power low voltage applications », 2016 IEEE International Symposium on Circuits and Systems (ISCAS. IEEE, 2016, et Costin Anghel et al., « 30 nm Tunnel FET with improved performance and reduce ambipolar current », IEEE Transactions on Electron Devices, vol. 58, Edition 6, juin 2011, des cellules SRAM à TFET compact et de fuite ultrafaible sont proposées en utilisant la propriété NDR des TFET. En raison d'un comportement unidirectionnel des TFET, l'architecture de DRAM 1T1C classique ne peut pas fonctionner de manière similaire comme pour le CMOS.

### RESUME DE L'INVENTION

Il existe un besoin de proposer une nouvelle architecture de cellule de bit mémoire, ou verrou mémoire, qui puisse résoudre au moins certains des inconvénients des verrous mémoire décrits antérieurement, notamment qui ne soit pas négativement impactée par une augmentation significative de la fuite de condensateur et qui puisse être utilisée comme un verrou de type DRAM 1T1C.

Il est décrit ainsi un verrou mémoire comprenant au moins :
- un premier TFET;
- un condensateur;
- un noeud de stockage formé par la connexion d'une première borne du condensateur à une première électrode du premier TFET correspondant à la source ou au drain du premier TFET ;
- un circuit de commande apte à fournir un premier potentiel électrique sur une seconde borne du condensateur, un deuxième potentiel électrique sur la grille du premier TFET et un troisième potentiel électrique sur une seconde électrode du premier TFET correspondant au drain du premier TFET lorsque la première électrode du premier TFET correspond à la source du premier TFET, ou à la source du premier TFET lorsque la première électrode du premier TFET correspond au drain du premier TFET ;
dans lequel le circuit de commande est configuré pour fournir, pendant une rétention d'un bit stocké dans le noeud de stockage, les premier, deuxième et troisième potentiels électriques avec des valeurs telles que :
- lorsque le bit stocké a une première valeur (basse, c'est-à-dire bit « 0 », ou haute, c'est-à-dire bit « 1 »), le premier TFET est polarisé en inverse dans un état dans lequel un courant de conduction est obtenu par effet tunnel de bande à bande dans le premier TFET avec une valeur plus élevée qu'un courant de fuite du condensateur ;
- lorsque le bit stocké a une seconde valeur différente de la première valeur (haute lorsque la première valeur est basse, ou basse lorsque la première valeur est haute), le premier TFET est polarisé en inverse avec un courant de blocage obtenu dans le premier TFET avec une valeur plus faible que le courant de fuite du condensateur.

Selon une autre définition, il est proposé un verrou mémoire comprenant au moins :
- un premier transistor à effet de champ tunnel, TFET ;
- un condensateur;
- un noeud de stockage formé par la connexion d'une première borne du condensateur à une première électrode du premier TFET correspondant à la source ou au drain du premier TFET et configuré pour stocker un bit tel que des valeurs basse et haute du potentiel électrique du noeud de stockage soient représentatives de la valeur du bit stocké ;

- un circuit de commande configuré pour fournir un premier potentiel électrique sur une ligne de masse virtuelle, un deuxième potentiel électrique sur une ligne de mot connectée à la grille du premier TFET et un troisième potentiel électrique sur une ligne de bit ;
dans lequel :
- dans une première configuration, une seconde borne du condensateur est connectée à la ligne de masse virtuelle, la première électrode du premier TFET correspond à sa source lorsque le premier TFET est de type n ou à son drain lorsque le premier TFET est de type p, une seconde électrode du premier TFET, correspondant à son drain lorsque la première électrode correspond à la source ou à sa source lorsque la première électrode correspond au drain, est connectée à la ligne de bit, ou
- dans une deuxième configuration, une seconde borne du condensateur est connectée à la ligne de bit, la première électrode du premier TFET correspond à son drain lorsque le premier TFET est de type n ou à sa source lorsque le premier TFET est de type p, une seconde électrode du premier TFET, correspondant à sa source lorsque la première électrode correspond au drain ou à son drain lorsque la première électrode correspond à la source, est connectée à la ligne de bit ;
et dans lequel le circuit de commande est configuré pour fournir, pendant une rétention d'un bit stocké dans le noeud de stockage, les premier, deuxième et troisième potentiels électriques avec des valeurs telles que :
- lorsque le bit stocké a une première valeur, une première tension de polarisation appliquée entre la source et le drain du premier TFET a une valeur absolue inférieure à celle d'une deuxième tension de polarisation appliquée entre les première et deuxième bornes du condensateur et polarise en inverse le premier TFET tel qu'un courant de conduction obtenu par effet tunnel de bande à bande dans le premier TFET ait une valeur plus élevée qu'un courant de fuite du condensateur ;
- lorsque le bit stocké a une seconde valeur différente de la première valeur, la première tension de polarisation a une valeur absolue supérieure à celle de la deuxième tension de polarisation et polarise en inverse le premier TFET tel qu'un courant de blocage obtenu dans le premier TFET ait une valeur plus faible que le courant de fuite du condensateur.

Ce verrou mémoire forme un verrou mémoire de type DRAM 1T1C qui se comporte comme un verrou statique, sans contrainte de rafraîchissement. La suppression du rafraîchissement permet :
- d'augmenter le débit du système embarquant des verrous mémoire de l'invention (entre environ 10 % et 15 %) ;
- d'économiser du temps;
- de simplifier la commande des verrous mémoire ;
- d'économiser de l'énergie.

Un autre avantage de ce verrou mémoire est que le courant de fuite du condensateur est utilisé pour maintenir la rétention d'un bit dans le noeud de stockage. Ainsi, le courant de fuite du condensateur est ici utile et non pas un inconvénient dans ce verrou mémoire. En conséquence, un condensateur de fine épaisseur d'oxyde équivalente (EOT pour « Equivalent-Oxide-Thickness ») de fuite plus grande que celle imposée par l'IRTS peut être utilisé, relâchant la pression sur la technologie et permettant une mise à l'échelle au-delà de la prédiction de l'IRTS.

Ce verrou mémoire peut être implémenté (sans s'y limiter) par l'utilisation de Si-TFET et condensateur MIM en utilisant un procédé FDSOI-CMOS de 28 nm qui permet une co-fabrication de CMOS et TFET.

De surcroît, en raison de l'absence de rafraîchissement, la quantité de capacité requise par noeud se réduit. Cela, rajouté à la fine EOT, réduit significativement la taille et le coût de la fabrication de condensateur.

Ce verrou mémoire peut être conçu de diverses manières, de telle sorte que :
1) la source du premier TFET soit connectée au condensateur, et le drain du premier TFET soit connecté à la ligne de bits lorsque le premier TFET est de type n ou à la ligne de masse virtuelle lorsque le premier TFET est de type P, ou
2) le drain du premier TFET soit connecté au condensateur, et la source du premier TFET soit connectée à la ligne de masse virtuelle lorsque le premier TFET est de type n ou à la ligne de bits lorsque le premier TFET est de type p.

Dans une première configuration, la première électrode du premier TFET correspond à la source du premier TFET lorsque le premier TFET est un TFET de type n ou au drain du premier TFET lorsque le premier TFET est un TFET de type p. Dans ce cas :
- lorsque la valeur du bit stocké est basse, le premier TFET est polarisé en inverse dans un état dans lequel un courant de conduction est obtenu par effet tunnel de bande à bande dans le premier TFET avec une valeur plus élevée qu'un courant de fuite du condensateur lorsque le premier TFET est un TFET de type n, et le premier TFET est polarisé en inverse avec un courant de blocage obtenu dans le premier TFET avec une valeur plus faible que le courant de fuite du condensateur lorsque le premier TFET est un TFET de type p ;
- lorsque la valeur du bit stocké est haute, le premier TFET est polarisé en inverse avec un courant de blocage obtenu dans le premier TFET avec une valeur plus faible que le courant de fuite du condensateur lorsque le premier TFET est un TFET de type n, et le premier TFET est polarisé en inverse dans un état dans lequel un courant de conduction est obtenu par effet tunnel de bande à bande dans le premier TFET avec une valeur plus haute qu'un courant de fuite du condensateur lorsque le premier TFET est un TFET de type p.

Dans une seconde configuration, la première électrode du premier TFET correspond au drain du premier TFET lorsque le premier TFET est un TFET de type n ou à la source du premier TFET lorsque le premier TFET est un TFET de type p. Dans ce cas :
- lorsque la valeur du bit stocké est haute, le premier TFET est polarisé en inverse dans un état dans lequel un courant de conduction est obtenu par effet tunnel de bande à bande dans le premier TFET avec une valeur plus élevée qu'un courant de fuite du condensateur ;
- lorsque la valeur du bit stocké est basse, le premier TFET est polarisé en inverse avec un courant de blocage obtenu dans le premier TFET avec une valeur plus faible que le courant de fuite du condensateur.

Autrement dit, le circuit de commande peut être configuré pour fournir les premier, deuxième et troisième potentiels électriques avec des valeurs telles que :
- dans la première configuration, lorsque la valeur du potentiel électrique du noeud de stockage est basse, la première tension de polarisation polarise en inverse le premier TFET tel que le courant de conduction obtenu par effet tunnel de bande à bande dans le premier TFET ait une valeur plus élevée que le courant de fuite du condensateur ;
- dans la première configuration, lorsque la valeur du potentiel électrique du noeud de stockage est haute, la première tension de polarisation polarise en inverse le premier TFET tel que le courant de blocage obtenu dans le premier TFET ait une valeur plus faible que le courant de fuite du condensateur ;
- dans la deuxième configuration, lorsque la valeur du potentiel électrique du noeud de stockage est basse, la première tension de polarisation polarise en inverse le premier TFET tel que le courant de blocage obtenu dans le premier TFET ait une valeur plus faible que le courant de fuite du condensateur ;
- dans la deuxième configuration, lorsque la valeur du potentiel électrique du noeud de stockage est haute, la première tension de polarisation polarise en inverse le premier TFET tel que le courant de conduction obtenu par effet tunnel de bande à bande dans le premier TFET ait une valeur plus élevée que le courant de fuite du condensateur.

Le circuit de commande peut être configuré pour fournir, pendant la rétention d'un bit stocké dans le noeud de stockage, les premier, deuxième et troisième potentiels électriques de telle sorte que la valeur absolue du premier potentiel électrique soit supérieure à la valeur absolue du troisième potentiel électrique, et que la valeur absolue du deuxième potentiel électrique soit supérieure à la valeur absolue du premier potentiel électrique. Par exemple, le circuit de commande peut fournir trois ou quatre potentiels électriques différents pour effectuer la rétention d'un bit dans le verrou mémoire.

Le circuit de commande peut être configuré pour fournir, pendant la rétention d'un bit stocké dans le noeud de stockage, les premier, deuxième et troisième potentiels électriques de telle sorte que la valeur absolue du premier potentiel électrique soit égale à la valeur d'un potentiel électrique correspondant à un bit de valeur haute (bit « 1 »), et/ou que la valeur absolue du troisième potentiel électrique soit égale à la valeur d'un potentiel électrique correspondant à un bit de valeur basse (bit « 0 »).

Le circuit de commande peut être configuré pour fournir, pendant la rétention d'un bit stocké dans le noeud de stockage, les premier, deuxième et troisième potentiels électriques de telle sorte que la valeur absolue du premier potentiel électrique soit sensiblement égale à la valeur haute du potentiel électrique du noeud de stockage, et/ou que la valeur absolue du troisième potentiel électrique soit sensiblement égale à la valeur basse du potentiel électrique du noeud de stockage.

Le circuit de commande peut être configuré pour fournir, pendant une écriture d'un bit dans le noeud de stockage, les premier, deuxième et troisième potentiels électriques de telle sorte que :
- le premier potentiel électrique inclut une impulsion d'écriture déclenchant l'écriture du bit dans le noeud de stockage, et la valeur du troisième potentiel électrique peut être représentative de la valeur du bit à écrire, par exemple pendant au moins une partie de l'impulsion d'écriture ;
- lorsque la valeur du bit à écrire est basse ou correspond à la valeur basse du potentiel électrique du noeud de stockage, le premier TFET peut être polarisé en inverse dans un état dans lequel un courant de conduction est obtenu par émission thermoionique sur la barrière formée dans le premier TFET pendant l'impulsion d'écriture, déchargeant le noeud de stockage par le biais du premier TFET ;
- lorsque la valeur du bit à écrire est haute ou correspond à la valeur haute du potentiel électrique du noeud de stockage, le premier TFET peut être polarisé en direct.

Le verrou mémoire peut être tel que :
- pendant l'écriture d'un bit de valeur basse ou correspondant à la valeur basse du potentiel électrique du noeud de stockage, la valeur absolue du deuxième potentiel électrique est supérieure ou égale à la valeur absolue du troisième potentiel électrique, la valeur absolue du premier potentiel électrique pendant l'impulsion d'écriture est égale ou supérieure à la valeur absolue du deuxième potentiel électrique, et éventuellement la valeur absolue du premier potentiel électrique avant et après l'impulsion d'écriture est comprise entre les valeurs absolues des deuxième et troisième potentiels électriques, et
- pendant l'écriture d'un bit de valeur haute ou correspondant à la valeur haute du potentiel électrique du noeud de stockage, la valeur absolue du troisième potentiel électrique est égale ou supérieure à la valeur absolue du deuxième potentiel électrique, et la valeur absolue du premier potentiel électrique pendant l'impulsion d'écriture est égale ou supérieure à la valeur absolue du deuxième potentiel électrique, et éventuellement la valeur absolue du premier potentiel électrique avant et après l'impulsion d'écriture est inférieure aux valeurs absolues des deuxième et troisième potentiels électriques.

Le circuit de commande peut être configuré pour fournir, pendant l'écriture d'un bit dans le noeud de stockage, les premier et troisième potentiels électriques de telle sorte que :
- pendant l'écriture d'un bit de valeur basse, la valeur absolue du troisième potentiel électrique soit égale à la valeur du potentiel électrique correspondant au bit de valeur basse, et/ou
- la valeur absolue du premier potentiel électrique avant et après l'impulsion d'écriture soit égale à la valeur du potentiel électrique correspondant à un bit de valeur haute.

Le verrou mémoire peut comprendre en outre une ligne de bits connectée à une seconde électrode du premier TFET, et dans lequel le circuit de commande est configuré pour appliquer, pendant une lecture d'un bit stocké dans le noeud de stockage, un potentiel électrique de pré-charge sur la ligne de bits puis une tension d'impulsion sur la grille du premier TFET de telle sorte que la valeur du potentiel électrique sur la ligne de bits baisse pendant l'impulsion seulement si la valeur du bit stocké est basse.

Le verrou mémoire peut comprendre en outre un second TFET ayant sa grille connectée au noeud de stockage. Le second TFET peut comporter une première électrode, correspondant à sa source lorsque le second TFET est de type n ou à son drain lorsque le second TFET est de type p, reliée à la ligne de mots.

Le verrou mémoire peut comprendre en outre :
- une ligne de mots connectée à la grille du premier TFET et à une première électrode du second TFET, la première électrode du second TFET étant la source du second TFET lorsque le second TFET est un TFET de type n ou le drain du second TFET lorsque le second TFET est un TFET de type p,
- une ligne de bits d'écriture connectée à une seconde électrode du premier TFET,
- une ligne de bits de lecture connectée à une seconde électrode du second TFET, correspondant à son drain lorsque la première électrode correspond à sa source ou à sa source lorsque la première électrode correspond à son drain,
et le circuit de commande peut être configuré pour appliquer, pendant une lecture d'un bit stocké dans le noeud de stockage, une impulsion de lecture sur la ligne de mots de telle sorte que la valeur d'un potentiel électrique sur la ligne de bits de lecture baisse pendant l'impulsion seulement si la valeur de bit stocké ou du potentiel électrique du noeud de stockage est haute.

L'invention se rapporte également à un réseau de verrous DRAM, comprenant :
- plusieurs verrous mémoire tels que divulgués précédemment et agencés selon un réseau de plusieurs rangées et plusieurs colonnes ;
- plusieurs lignes de mots, chacune étant connectée à la grille du premier TFET de chacun des verrous mémoire appartenant à une même rangée du réseau ;
- plusieurs lignes de masse virtuelle, chacune étant connectée à la seconde borne du condensateur de chacun des verrous mémoire appartenant à une même rangée du réseau ;
et dans lequel :
- chaque ligne de bits est connectée à chacun des verrous mémoire appartenant à une même colonne du réseau ;
- le circuit de commande est commun à tous les verrous mémoire du réseau de verrous DRAM et configuré pour fournir les potentiels électriques auxdits verrous mémoire par le biais des lignes de bits, des lignes de mots et des lignes de masse virtuelle.

Le circuit de commande peut être configuré pour réaliser une opération d'écriture collectivement pour une rangée de verrous mémoire du réseau de telle sorte que :
- la valeur absolue d'un potentiel électrique appliqué sur la ligne de mots connectée aux verrous mémoire de ladite une rangée de verrous mémoire soit supérieure à la valeur absolue d'un potentiel électrique appliqué sur les lignes de mots connectées aux autres verrous mémoire, puis
- les valeurs absolues des potentiels électriques appliqués sur toutes les lignes de bits soient fixées selon les valeurs des bits à écrire dans ladite une rangée de verrous mémoire, puis
- une impulsion d'écriture est appliquée sur la ligne de masse virtuelle connectée aux verrous mémoire de ladite une rangée de verrous mémoire.

Le circuit de commande peut être configuré pour réaliser une opération de lecture collectivement pour une rangée de verrous mémoire du réseau de telle sorte que :
- la valeur absolue des potentiels électriques appliqués sur toutes les lignes de mots soit basse, puis
- des potentiels électriques de pré-charge soient appliqués sur toutes les lignes de bits, puis
- une impulsion de lecture soit appliquée sur la ligne de mots connectée aux verrous mémoire de ladite une rangée de verrous mémoire.

L'invention se rapporte également à un réseau de verrous SRAM, comprenant :
- plusieurs verrous mémoire tels que décrits précédemment et agencés selon un réseau de plusieurs rangées et plusieurs colonnes ;
- plusieurs lignes de mots, chacune étant connectée à la grille du premier TFET et à la première électrode du second TFET de chacun des verrous mémoire appartenant à une même rangée du réseau ;
- plusieurs lignes de masse virtuelle, chacune étant connectée à la seconde borne du condensateur de chacun des verrous mémoire appartenant à une même rangée du réseau ;
et dans lequel :
- chaque ligne de bits de lecture et chaque ligne de bits d'écriture sont connectées à chacun des verrous mémoire appartenant à une même colonne du réseau ;
- le circuit de commande est commun à tous les verrous mémoire du réseau de verrous SRAM et configuré pour apporter les potentiels électriques auxdits verrous mémoire par le biais des lignes de bits de lecture, des lignes de bits d'écriture, des lignes de mots et des lignes de masse virtuelle.

Le circuit de commande peut être configuré pour réaliser une opération d'écriture collectivement pour une rangée de verrous mémoire du réseau de telle sorte que :
- la valeur absolue d'un potentiel électrique appliqué sur la ligne de mots connectée aux verrous mémoire de ladite une rangée de verrous mémoire soit supérieure à la valeur absolue d'un potentiel électrique appliqué sur les lignes de mots connectées aux autres verrous mémoire, puis
- les valeurs absolues des potentiels électriques appliqués sur toutes les lignes de bits d'écriture soient fixées selon les valeurs des bits à écrire dans ladite une rangée de verrous mémoire, puis
- une impulsion d'écriture soit appliquée sur la ligne de masse virtuelle connectée aux verrous mémoire de ladite une rangée de verrous mémoire.

Le circuit de commande peut être configuré pour réaliser une opération de lecture collectivement pour une rangée de verrous mémoire du réseau de telle sorte que :
- la valeur absolue des potentiels électriques appliqués sur toutes les lignes de mots soit haute, puis
- une impulsion de lecture soit appliquée sur la ligne de mots connectée aux verrous mémoire de ladite une rangée de verrous mémoire.

L'invention se rapporte également à une bascule bistable comprenant au moins :
- des premier et second verrous mémoire tels que décrits ci-dessus ;
- un premier inverseur ayant une entrée formant l'entrée de la bascule bistable et une sortie connectée au noeud de stockage du premier verrou ;
- un second inverseur ayant une entrée connectée au noeud de stockage du premier verrou et une sortie connectée au noeud de stockage du second verrou.

### BREVE DESCRIPTION DES DESSINS

D'autres caractéristiques et avantages de l'invention ressortiront plus clairement à a lecture de la description ci-après, faite en référence aux dessins annexés, sur lesquels :
- la figure 1 montre la caractéristique I_{D}(V_{DS}) d'un n-TFET polarisé en inverse, pour différentes valeurs de V_{GS} ;
- les figures 2a à 2c montrent symboliquement les différents comportements d'un TFET polarisé en inverse ;
- la figure 3 montre un verrou mémoire 1T1C selon un mode de réalisation particulier de l'invention ;
- la figure 4 montre un réseau de verrous DRAM 1T1C selon un mode de réalisation particulier de l'invention ;
- la figure 5 montre des formes d'onde obtenues pendant une opération d'écriture dans un verrou mémoire 1T1C selon l'invention ;
- la figure 6 montre des formes d'onde obtenues pendant une opération de lecture dans un verrou mémoire 1T1C selon l'invention ;
- la figure 7 montre un verrou mémoire 2T1C selon un mode de réalisation particulier de l'invention ;
- la figure 8 montre un réseau de verrous SRAM 2T1C selon un mode de réalisation particulier de l'invention ;
- la figure 9 montre des formes d'onde obtenues pendant une opération d'écriture dans un verrou mémoire 2T1C selon l'invention ;
- la figure 10 montre des formes d'onde obtenues pendant une opération de lecture dans un verrou mémoire 2T1C selon l'invention ;
- la figure 11 montre schématiquement un réseau de verrous selon l'invention ;
- la figure 12 montre schématiquement une bascule bistable incluant des verrous mémoire selon l'invention ;
- la figure 13 montre un verrou mémoire 1T1C selon un autre mode de réalisation particulier de l'invention ;
- la figure 14 montre un réseau de verrous DRAM 1T1C selon un autre mode de réalisation particulier de l'invention ;
- les figures 15 et 16 montrent des formes d'onde obtenues pendant une opération d'écriture dans un verrou mémoire 1T1C selon l'invention.

Des parties identiques, similaires ou équivalentes des différentes figures décrites ci-dessous présentent les mêmes références numériques à des fins de clarté entre les différentes figures.

Les différentes parties montrées sur les figures ne sont pas nécessairement tracées à l'échelle, de manière à rendre les figures plus lisibles.

Il ne faut pas comprendre que les différentes possibilités (alternatives et modes de réalisation) s'excluent mutuellement, celles-ci pouvant donc être combinées les unes avec les autres.

### DESCRIPTION DETAILLEE DE MODES DE REALISATION PARTICULIERS

Les TFET sont des jonctions à grille p-i-n polarisées en inverse qui fonctionnent par effet tunnel, où le potentiel électrostatique de la région intrinsèque est commandé par un contact de grille. Les TFET utilisés dans les verrous mémoire SRAM décrits ci-dessous sont calibrés et conçus sur des données similaires à celles divulguées dans le document C. ANGHEL et al., « 30-nm Tunnel FET with improved performance and reduce ambipolar current », IEEE Transactions on Electron Devices, 2011.

Par exemple :
- les TFET sont construits en utilisant des espaceurs à faible permittivité diélectrique k(SiO₂) et un diélectrique de grille à forte permittivité diélectrique (HfO₂) ;
- les longueurs de grille et des espaceurs sont chacune de 30 nm ;
- l'épaisseur physique du diélectrique de grille est de 3 nm ;
- l'épaisseur du film de silicium (tSi) utilisé pour former les régions de source, de drain et de canal est de 4 nm.

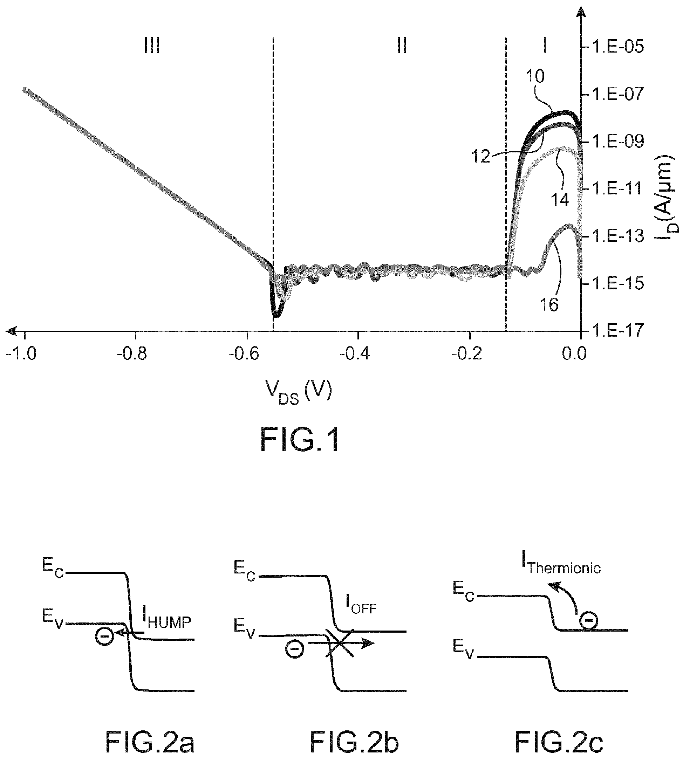

La figure 1 montre la caractéristique I_{D}(V_{DS}) d'un n-TFET polarisé en inverse, pour différentes valeurs de V_{GS} : V_{GS} = 1 V pour la courbe 10, V_{GS} = 0,75 V pour la courbe 12, V_{GS} = 0,5 V pour la courbe 14 et V_{GS} = 0,25 V pour la courbe 16. Pour cette caractéristique, trois régions correspondant à trois comportements différents du TFET obtenu pour différentes plages de valeurs de V_{DS} peuvent être distinguées comme suit :
- Région I, qui est qualifiée de « bosse » (pour « hump »), dans laquelle un courant de conduction I_{HUMP} est obtenu dans le TFET par effet tunnel de bande à bande (le mécanisme d'injection de charge correspondant à l'effet tunnel de bande à bande est symboliquement montré sur la figure 2a) ;
- Région II, qui est qualifiée de « région de courant plat », dans laquelle le courant de conduction obtenu dans la région I n'est plus obtenu en raison des bandes non chevauchantes (comme montré symboliquement sur la figure 2b). Seul un courant de blocage I_{OFF} est obtenu dans cette région ;
- Région III, qui est qualifiée d'« activation p-i-n », dans laquelle le mécanisme d'injection de charge est dominé par l'émission thermoionique sur la barrière, créant un courant appelé I_{Thermionic} comme montré symboliquement sur la figure 2c. Dans cette région III, le TFET a un comportement similaire à un court-circuit.

Pour la région III, la caractéristique de sortie polarisée en inverse est qualifiée de « unidirectionnelle » en raison du fait que la grille perd la commande sur le TFET pour des tensions de drain négatives élevées.

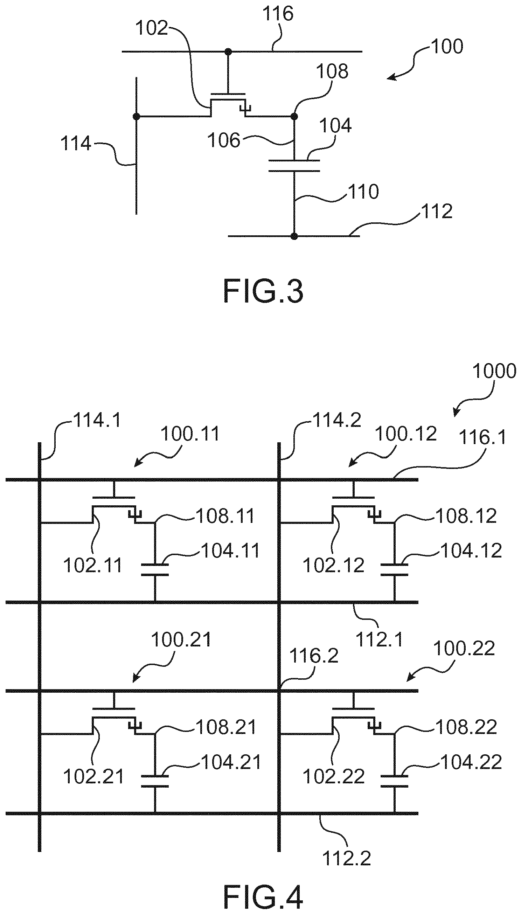

Un verrou mémoire 1T1C TFET 100 selon un mode de réalisation particulier est montré sur la figure 3 et décrit ci-dessous. Le verrou 100 est ici réalisé selon une première configuration.

Le verrou 100 comprend un TFET 102, ici un n-TFET, et un condensateur 104. Le TFET 102 forme un transistor d'accès du verrou 100, et est par exemple un Si-TFET. Par exemple, le condensateur 104 peut être un condensateur à tranchée ou un condensateur MIM (Métal-Isolant-Métal). La source du TFET 102 est connectée à une première borne 106 du condensateur 104, cette connexion formant un noeud de stockage 108 du verrou 100. Une seconde borne 110 du condensateur 104 est connectée à une ligne de masse virtuelle 112 du verrou 100.

Le verrou 100, qui est destiné à être utilisé dans un réseau de verrous mémoire, comprend également une ligne de bits 114 connectée au drain du TFET 102 et une ligne de mots 116 connectée à la grille du TFET 102.

La ligne de bits 114, la ligne de masse virtuelle 112 et la ligne de mots 116 peuvent être réalisées dans un niveau de métal agencé au-dessus de la zone active du TFET du verrou 100.

Le verrou 100 comprend également un circuit de commande 101 (non montré sur la figure 3) configuré pour fournir des tensions, ou des potentiels électriques, d'alimentation sur la ligne de masse virtuelle 112, la ligne de bits 114 et la ligne de mots 116.

Un exemple d'un réseau de verrous DRAM 1000 est montré sur la figure 4. Le réseau de verrous 1000 comprend n rangées et m colonnes de n x m verrous 100.11 à 100.nm. Sur la figure 4, seuls quatre verrous 100, référencés 100.11 à 100.22, sont montrés. Des mots de données sont ici stockés horizontalement, chacun dans une rangée de verrous 100.

Chaque ligne de mots 116 est connectée aux verrous 100 agencés sur la même rangée du réseau 1000. La ligne de mots référencée 116.x est ainsi connectée aux grilles des TFET 102.x1 à 102.xm appartenant à la x^{ième} rangée du réseau 1000. Sur la figure 4, seules deux lignes de mots 116.1 (connectée aux grilles des TFET 102.11 et 102.12) et 116.2 (connectée aux grilles des TFET 102.21 et 102.22) sont montrées. De manière similaire aux lignes de mots 116, chaque ligne de masse virtuelle 112 est connectée aux verrous 100 agencés sur la même rangée du réseau. Sur la figure 4, seules deux lignes de masse virtuelle 112.1 (connectée aux condensateurs 104.11 et 104.12) et 112.2 (connectée aux condensateurs 104.21 et 104.22) sont montrées.

Chaque ligne de bits 114 est acheminée verticalement, c'est-à-dire connectée à tous les verrous 100 agencés dans une même colonne du réseau 1000. Sur la figure 4, seules deux lignes de bits 114.1 (connectée au drain des TFET 102.11 et 102.21) et 114.2 (connectée au drain des TFET 102.12 et 102.22) sont montrées.

Les différents modes de fonctionnement (rétention, écriture et lecture) du verrou mémoire 100 sont décrits ci-dessous.

Les éléments du verrou mémoire 100 sont conçus pour que pendant un mode de rétention, ou mode de stockage, du verrou 100, à savoir lorsqu'une valeur d'un bit est mémorisée et gardée dans le verrou mémoire 100, I_{OFF} (courant de blocage du TFET 102) << I_{LEAKCap} (courant de fuite du condensateur 104) << I_{HUMP} (courant de bosse du TFET 102, correspondant au courant I_{D} dans la région I montrée sur la figure 1). Par exemple, la valeur du rapport I_{HUMP}/I_{LEAKCap} peut être d'environ 10³, et la valeur du rapport I_{LEAKcap}/I_{OFF} peut être d'environ 10³. Plus généralement, ces courants peuvent être tels que I_{OFF}<I_{LEAKCap}<I_{HUMP}. Par exemple, I_{OFF} peut être plus faible que 10⁻¹⁵ A/100 nm, I_{LEAKCap} peut être égal à 10⁻¹⁴ A/cellule et peut être ajusté par les différentes technologies de capacité (c'est-à-dire tranchée, MIM cylindrique/support, etc.), et I_{HUMP} peut être ajusté par la grille.

Pendant un mode de rétention du verrou 100, quelle que soit la valeur du bit stocké dans le noeud de stockage 108 (un bit logique « 1 » ou « 0 »), le verrou 100 se comporte comme une mémoire de stockage statique. Pour obtenir ce comportement, la valeur du potentiel électrique appliqué sur la ligne de bits 114 est basse et correspond à celle du potentiel électrique obtenu sur le noeud de stockage 108 lorsqu'un bit logique « 0 » est stocké, par exemple 0 V. La valeur du potentiel électrique appliqué sur la ligne de masse virtuelle 112 correspond à celle du potentiel électrique obtenu dans le noeud de stockage 108 lorsqu'un bit logique « 1 » est stocké, par exemple 0,5 V. La valeur du potentiel électrique appliqué sur la ligne de mots 116 est haute, notamment supérieure à celle d'un bit logique « 1 », par exemple 1 V.

De manière générale, des valeurs basse et haute du potentiel électrique du noeud de stockage 108 sont représentatives de la valeur du bit stocké. Il est par exemple possible qu'un bit de valeur logique « 1 » corresponde à la valeur haute du potentiel électrique maintenu sur le noeud de stockage 108, par exemple égale à environ 0,5 V, et qu'un bit de valeur logique « 0 » corresponde à la valeur basse du potentiel électrique maintenu sur le noeud de stockage 108, par exemple égale à environ 0 V. Selon une autre convention, il est possible qu'un bit de valeur logique « 1 » corresponde à la valeur basse du potentiel électrique maintenu sur le noeud de stockage 108, et qu'un bit de valeur logique « 0 » corresponde à la valeur haute du potentiel électrique maintenu sur le noeud de stockage 108. Dans la suite de la description, un bit de valeur logique « 1 » correspond à la valeur haute du potentiel électrique maintenu sur le noeud de stockage 108 et égale à environ 0,5 V, et qu'un bit de valeur logique « 0 » corresponde à la valeur basse du potentiel électrique maintenu sur le noeud de stockage 108 et égale à environ 0 V.

Lorsqu'un bit logique « 0 » est stocké dans le noeud de stockage 108, le TFET 102 est polarisé avec une tension V_{DS} basse (0 V) et une tension V_{GS} haute (1 V). Du fait que la valeur du potentiel électrique sur la ligne de masse virtuelle 112 (par exemple 0,5 V) est plus haute que celle du potentiel électrique sur le noeud de stockage 108 (par exemple 0 V), le courant de fuite I_{LEAKCap} du condensateur 104 tend à essayer de charger le noeud de stockage 108. Cela mène le TFET 102 à être polarisé en inverse (du fait que la tension V_{DS} tend à devenir négative) et à avoir un comportement correspondant à la région I divulguée précédemment dans laquelle le courant de conduction I_{HUMP} est obtenu dans le TFET par effet tunnel de bande à bande. Le noeud de stockage 108 commence ainsi la décharge due au courant I_{HUMP} à travers le TFET 102 dès que la valeur du potentiel électrique sur le noeud de stockage 108 devient supérieure à la valeur du potentiel électrique appliqué sur la ligne de bits 114, ici égal à 0 V. Puisque I_{HUMP} >> I_{LEAKCap} (la tension V_{GS} appliquée sur le TFET 102 est ici égale à 1V, ce qui permet d'avoir un courant I_{HUMP} important), le verrou 100 maintient le potentiel électrique sur le noeud de stockage 108 à 0 V, ou plus généralement à la valeur du potentiel électrique appliqué sur la ligne de bits 114, stockant un bit logique « 0 » de façon statique.

Lorsqu'un bit logique « 1 » est stocké sur le noeud de stockage 108, la tension aux bornes du condensateur 104 est égale à 0 V et le TFET 102 est polarisé en inverse avec V_{DS} = -0,5V. Le comportement du TFET 102 correspond à la région II divulguée antérieurement. Le noeud de stockage 108 tend à se décharger en raison du courant I_{OFF} à travers le TFET 102 alors que I_{LEAKCap} tend à charger le noeud de stockage 108 dès que la valeur du potentiel électrique sur le noeud de stockage 108 vient en dessous de la valeur du potentiel électrique sur la ligne de masse virtuelle 112 (par exemple 0,5 V). Puisque I_{OFF} << I_{LEAKCap}, la valeur de 0,5 V, ou plus généralement la valeur du potentiel électrique appliqué sur la ligne de masse virtuelle 112, est maintenue sur le noeud de stockage 108, stockant un bit logique « 1 » de façon statique.

En raison de la nature statique du stockage pendant le mode de rétention, aucun rafraîchissement n'est requis pour le verrou 100, ce qui procure une amélioration significative en termes de débit et de consommation d'énergie.

On décrit à présent une opération d'écriture dans le verrou mémoire 100.

Lorsque le verrou mémoire 100 appartient à un réseau de verrous 1000 comme le montre la figure 4, à savoir dans lequel chaque ligne de bits 114 est partagée par tous les verrous d'une même colonne et dans lequel chacune ligne de mots 116 et chaque ligne de masse virtuelle 112 sont partagées par tous les verrous d'une même rangée, une opération d'écriture est réalisée dans tous les verrous de la rangée auxquels le verrou 100 appartient en raison du partage de la ligne de mots et de la ligne de masse virtuelle par ces verrous.

La première étape de l'opération d'écriture est d'abaisser les valeurs sur les lignes de mots 116 à 0V, sauf la ligne de mots connectée à la rangée de verrous destinés à être écrits pour lesquels la valeur est gardée haute comme dans le mode de rétention, par exemple 1 V.

La valeur du potentiel électrique appliqué sur la ligne de bits 114 associée au verrou 100 est fixée selon la valeur du bit logique destiné à être écrit dans le noeud de stockage 108. Dans l'exemple décrit ici, lorsqu'un bit logique « 0 » est destiné à être écrit dans le verrou 100, la valeur du potentiel électrique appliqué sur la ligne de bits 114 est égale à 0 V. Lorsqu'un bit logique « 1 » est destiné à être écrit dans le verrou 100, la valeur du potentiel électrique appliqué sur la ligne de bits 114 est égale à 1,5 V, ce qui conduit à élever la valeur du noeud de stockage 108 en raison du courant direct du TFET 102. Cela mène à une quasi égalisation des tensions dans le noeud 108 que le verrou stocke un bit « 0 » ou « 1 ». Cela peut être considéré comme une phase « d'initialisation » pour l'opération d'écriture « 1 » avant que l'impulsion soit appliquée sur la ligne de masse virtuelle 112.

Lorsque l'on considère le réseau 1000, l'opération d'écriture est réalisée pour tous les verrous mémoire appartenant à une rangée du réseau. Dans ce cas, les potentiels électriques appliqués sur toutes les lignes de bits 114.1 à 114.m du réseau 1000 sont fixés selon les valeurs des bits destinées à être stockées dans les verrous mémoire de cette rangée.

Une impulsion d'écriture est ensuite appliquée sur la ligne de masse virtuelle 112 connectée au verrou mémoire 100. Pendant cette impulsion, le potentiel électrique sur la ligne de masse virtuelle 112 est par exemple élevé de 0,5 V à 1,5 V. Cette impulsion sur la ligne de masse virtuelle 112 aboutit à un ΔV sur le noeud de stockage 108 similaire au ΔV de cette impulsion (ΔV = 1,5 - 0,5 = 1 V dans cet exemple) en raison du couplage capacitif entre les deux noeuds sur les deux électrodes du condensateur 104. A cause de cela, la valeur de la tension sur le noeud de stockage 108 tend à faire balancer le ΔV avec le front montant de l'impulsion. Si un bit logique « 0 » est stocké dans le noeud de stockage 108 et si la valeur du potentiel électrique sur la ligne de bits 114 est de 0 V, la valeur dans le noeud de stockage 108 devient 1 V. Si un bit logique « 1 » est stocké dans le noeud de stockage 108 et/ou si la valeur du potentiel électrique sur la ligne de bits 114 est de 1,5 V, la valeur sur le noeud de stockage 108 devient 1,5 V.

Avec un potentiel électrique sur le noeud de stockage 108 égal à 1 V ou 1,5 V et une valeur sur la ligne de bits 114 égale à 0 V, le TFET 102 est polarisé en inverse et a une tension V_{DS} comprise entre -1V et -1,5 V, c'est-à-dire a un comportement correspondant à la région III précédemment divulguée en relation avec les figures 1 et 2. La valeur du potentiel électrique sur le noeud de stockage 108 est déchargée par émission thermoionique à travers le TFET 102, réduisant ainsi la valeur de V_{DS} sur le TFET 102 et donc également la valeur du potentiel électrique dans le noeud de stockage 108. Lorsque la valeur du potentiel électrique sur la ligne de bits 114 est égale à 1,5 V, la décharge du noeud de stockage 108 à travers le TFET 102, qui est polarisé en inverse et a un comportement correspondant à la région II, est minimale en raison du faible I_{OFF} comparé à un verrou ayant sa ligne de bits à 0 V. Cela aboutit à une différence de tension sur le noeud de stockage 108 entre le stockage d'un bit logique « 0 » et d'un bit logique « 1 ».

Cela est suivi par le front descendant de l'impulsion appliquée sur la ligne de masse virtuelle 112 pendant laquelle le potentiel électrique sur la ligne de masse virtuelle 112 est abaissé de 1,5 V à 0,5 V. Un ΔV de -1V est ainsi appliqué sur le noeud de stockage 108, amenant la valeur du noeud de stockage 108 à 0 V ou 0,5 V selon la valeur du bit logique stocké dans ce noeud 108.

A la fin de cette opération d'écriture, les valeurs sur toutes les lignes de bits 114 du réseau de verrous peuvent être abaissées à la valeur basse (0 V) et les valeurs sur toutes les lignes de mots 116 du réseau de verrous peuvent être élevées à la valeur haute (par exemple 1V), de telle sorte que tous les verrous retournent dans le mode de rétention.

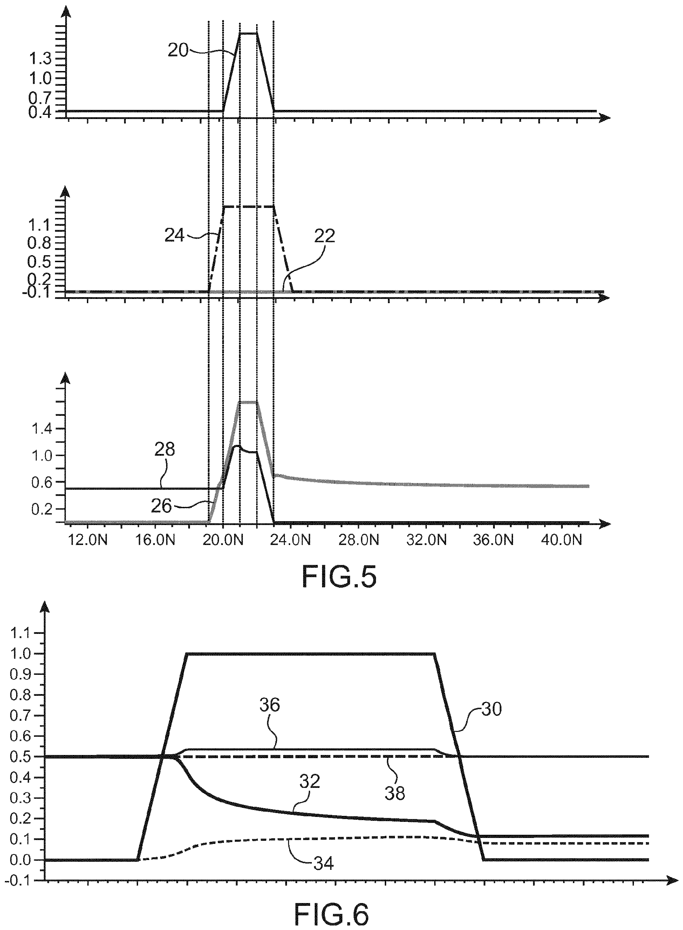

Des formes d'onde des signaux utilisés pendant une opération d'écriture sont montrées sur la figure 5.

La référence 20 désigne le signal appliqué sur la ligne de masse virtuelle 112, incluant l'impulsion d'écriture. La référence 22 désigne le signal appliqué sur la ligne de bits 114 pendant une écriture de « 0 », et la référence 24 désigne le signal appliqué sur la ligne de bits 114 pendant une écriture de « 1 ». La référence 26 désigne le potentiel électrique obtenu dans le noeud de stockage 108 pendant une écriture de « 1 », avec « 0 » initialement stocké dans le noeud de stockage 108. La référence 28 désigne le potentiel électrique obtenu dans le noeud de stockage 108 pendant une écriture de « 0 », avec « 1 » initialement stocké dans le noeud de stockage 108.

Une opération de lecture est réalisée en abaissant les valeurs sur toutes les lignes de mots 116 pour toutes les rangées de verrous 100. Toutes les lignes de bits 114 sont alors pré-chargées à 0,5 V. La valeur sur la ligne de mots 116 de la rangée de verrous 100 destinés à être lus est ensuite élevée à 1V. Pendant l'opération de lecture, les potentiels électriques appliqués sur toutes les lignes de masse virtuelle 112 du réseau sont par exemple égaux à 0,5 V.

Des formes d'onde d'opération de lecture sont montrées sur la figure 6 pour lire « 0 » et « 1 ». La référence 30 désigne le signal appliqué sur la ligne de mots 116 de la rangée de verrous 100 à lire. Les références 32 et 34 désignent les potentiels électriques obtenus sur la ligne de bits 114 et dans le noeud de stockage 108 respectivement, pendant une opération de lecture d'un verrou dans lequel un bit « 0 » est stocké. Les références 36 et 38 désignent les potentiels électriques obtenus sur la ligne de bits 114 et dans le noeud de stockage 108 respectivement, pendant une opération de lecture d'un verrou dans lequel un bit « 1 » est stocké.

Si un bit « 1 » est stocké dans le verrou de lecture 100, la ligne de bits 114 connectée au verrou reste sur la valeur pré-chargée de 0,5 V, alors que la valeur du potentiel électrique sur la ligne de bits 114 se décharge si un bit « 0 » est stocké dans ce verrou. Comme le montre la courbe 34, l'opération de lecture change la valeur du potentiel électrique dans le noeud de stockage 108 dans lequel un « 0 » est stocké. Par conséquent, après une opération de lecture, une opération d'écriture différée peut être réalisée afin de réécrire les valeurs préalablement stockées dans les verrous.

Pendant la lecture d'un bit « 0 » stocké dans le noeud de stockage 108, la décharge de la ligne de bits 114 se produit en raison du partage de charge entre la capacité formée par la ligne de bits 114 et le condensateur 104 connectés au noeud de stockage 108. Contrairement à un DRAM CMOS classique dans lequel la valeur de la capacité connectée au noeud de stockage 108 dépend de la fuite à travers le transistor d'accès/le condensateur et la contrainte de temps de rétention, la contrainte de valeur de condensateur dans le verrou 100 est relaxée et une valeur de capacité, formée par le condensateur 104, égale à la capacité de la ligne de bits 114 est mise en oeuvre afin d'obtenir, par exemple une décharge de 0,25 V, ou plus généralement une décharge suffisante, sur la ligne de bits 114 par un partage de charge après l'activation de l'opération de lecture par élévation de la ligne de mots 116. Cela permet de réduire la valeur du condensateur 104.

Pendant des opérations de lecture et d'écriture, les rangées non sélectionnées de verrous du réseau 1000 ont des noeuds de stockage flottants car les TFET 102 dans ces verrous sont bloqués avec une tension de ligne de mots égale à 0 V. Une fois que l'accès (lecture ou écriture) est fini, le 0 V (« 0 » logique) est retenu/rétabli par le TFET 102, alors qu'une valeur de « 1 » logique, par exemple 0,5 V, est toujours rétablie par le courant de fuite I_{LEAKCap} du condensateur 104 comme expliqué précédemment pour le mode de rétention.

Les valeurs des potentiels électriques appliqués au cours des opérations de rétention, d'écriture et de lecture dans le verrou 100 peuvent être différentes de celles données ci-dessus.

Une mémoire DRAM peut être mise en oeuvre avec plusieurs réseaux 1000 de verrous mémoire 100. Une telle mémoire peut comprendre plusieurs sous-blocs mis en oeuvre en utilisant les réseaux de verrous. Les lignes de bits, lignes de mots et lignes de masse virtuelle sont propres à chaque sous-bloc qui peut avoir une sortie multiplexée. La sortie de la mémoire peut être placée sur des lignes de bits globales pendant une lecture qui sont communes pour un banc de mémoires complet. Les pilotes de ligne de mots et décodeur de colonne destinés à sélectionner la sortie multiplexée peuvent être placés sur les côtés partagés entre deux sous-blocs sur les deux côtés du pilote. Puisqu'une rangée entière est sélectionnée, elle fonctionne comme une logique de pilotage de ligne de mots distribuée. Pour une opération d'écriture, une forte capacité sur les masses virtuelles doit être puisée. Cela peut être réalisé par un grand pilote partagé qui peut être placé en haut et en bas des réseaux, et pourrait également être partagé pour des blocs au-dessus et en dessous du pilote en utilisant des multiplexeurs de portes de transmission pour la sélection. Il existe un seul pilote partagé qui peut piloter n'importe quelle rangée soit en dessus soit en dessous, selon l'accès sélectionné à travers les portes de transmission. Cela est réalisé pour réduire la surface et la consommation de puissance de fuite de la périphérie. Des pilotes de ligne de mots double peuvent être mis en oeuvre avec un pas de deux rangées de verrous.

La DRAM proposée peut être utilisée pour mettre en oeuvre des mémoires DDR (pour « Dual-Data Rate» ou débit de données double) pour des puces autonomes ou des DRAM embarquées. Dans le cas d'une implémentation DDR, en raison de la suppression de rafraîchissement, on peut gagner 3,8 % et 7,8 % de débit comparé à une DRAM CMOS standard (c'est-à-dire en supposant un préjudice minimal en raison du rafraîchissement) pour moins de 85 °C et plus de 85 °C, respectivement. Dans un système d'exécution effectif, la perte due à des cycles de rafraîchissement, qui interrompent le trafic d'exécution sur le DDR, peut aboutir à une perte de débit significativement plus élevée.

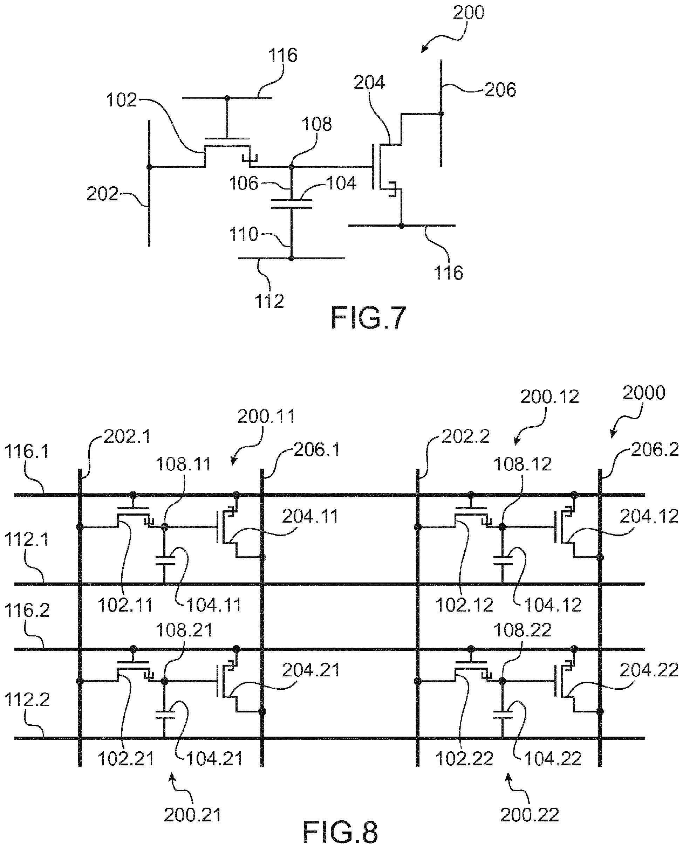

Un verrou mémoire 2T1C TFET 200 selon un mode de réalisation particulier est montré sur la figure 7 et décrit ci-dessous.

De manière similaire au verrou mémoire 100 décrit précédemment, le verrou mémoire 200 comprend le TFET 102, nommé ici premier TFET 102, le condensateur 104, la ligne de masse virtuelle 112 et la ligne de mots 116. Le drain du premier TFET 102 est connecté à une ligne de bits d'écriture 202. Le verrou 200 comprend également un second TFET 204. La grille du second TFET 204 est connectée au noeud de stockage 108. La source du second TFET 204 est connectée à la ligne de mots 116 et le drain du second TFET 204 est connecté à une ligne de bits de lecture 206.

Le verrou 200 comprend également le circuit de commande 101 (non montré sur la figure 7) configuré pour appliquer des potentiels électriques sur la ligne de masse virtuelle 112, la ligne de bits d'écriture 202, la ligne de bits de lecture 206 et la ligne de mots 116.

Un exemple d'un réseau de verrous SRAM 2T1C 2000 est montré sur la figure 8. Le réseau de verrous 2000 comprend n rangées et m colonnes de n x m verrous 200.11 à 200.nm. Sur la figure 8, seuls quatre verrous 200, référencés 200.11 à 200.22, sont montrés. Des mots de données sont ici stockés horizontalement, chacun dans une rangée de verrous 200.

Chaque ligne de mots 116 est connectée à des verrous 200 agencés sur la même rangée du réseau 2000. La ligne de mots référencée 116.x est ainsi connectée aux grilles des premiers TFET 102.x1 à 102.xm et aux sources des seconds TFET 204.x1 à 204.xm appartenant à la x^{ième} ligne. Sur la figure 8, seules deux lignes de mots 116.1 (connectée aux grilles des premiers TFET 102.11 et 102.12 et aux sources des seconds TFET 204.11 et 204.12) et 116.2 (connectée aux grilles des premiers TFET 102.21 et 102.22 et aux sources des seconds TFET 204.21 et 204.22) sont montrées. De façon similaire aux lignes de mots 116, chaque ligne de masse virtuelle 112 est connectée aux verrous 200 agencés sur la même rangée. Sur la figure 8, seules deux lignes de masse virtuelle 112.1 (connectée aux condensateurs 104.11 et 104.12) et 112.2 (connectée aux condensateurs 104.21 et 104.22) sont montrées.

Chaque ligne de bits d'écriture 202 et chaque ligne de bits de lecture 206 sont acheminées verticalement, à savoir connectée à tous les verrous 200 agencés dans une même colonne du réseau 2000. Sur la figure 8, seules deux lignes de bits d'écriture 202.1 (connectée au drain des premiers TFET 102.11 et 102.21) et 202.2 (connectée au drain des premiers TFET 102.12 et 102.22), et deux lignes de bits de lecture 206.1 (connectée au drain des seconds TFET 204.11 et 204.21) et 206.2 (connectée au drain des seconds TFET 204.12 et 204.22) sont montrées.

On décrit ci-dessous les différents modes de fonctionnement (rétention, écriture et lecture) du verrou 200.

Dans ce verrou 200, un verrou statique est mis en oeuvre en utilisant une propriété NDR de fuite du premier TFET 102 et du condensateur 104 de façon similaire au verrou mémoire 100 divulgué précédemment. Avec la condition que I_{OFF} (courant de blocage du TFET 102) << I_{LEAKCap} (courant de fuite à travers le condensateur 104) << I_{HUMP} (courant de bosse TFET 102, correspondant au courant I_{D} dans la région I montrée sur la figure 1), le verrou formé par le premier TFET 102 et le condensateur 104 stocke la valeur d'un bit logique « 0 » ou « 1 » de façon statique, de manière similaire au verrou statique formé par le verrou mémoire 100 divulgué précédemment. Pendant le mode de rétention, le potentiel électrique appliqué sur la ligne de masse virtuelle 112 est par exemple égal à 0,5 V, celui appliqué sur la ligne de bits d'écriture 202 est par exemple égal à 0 V, celui appliqué sur la ligne de bits de lecture 206 est par exemple égal à 1 V, et celui appliqué sur la ligne de mots 116 est par exemple égal à 1 V.

Dans le verrou mémoire 200, le second TFET 204 est utilisé comme port de lecture du verrou mémoire 200 et permet d'isoler la ligne de bits de lecture 206 du noeud de stockage 108 pendant la rétention.

Une opération d'écriture réalisée dans le verrou mémoire 200 est similaire à l'opération d'écriture décrite précédemment et réalisée dans le verrou mémoire 100. Dans le réseau 2000, toutes les rangées de verrous 200 ont leur ligne de mots 116 abaissée (par exemple égale à 0 V) sauf celle écrite pour laquelle la valeur est gardée haute comme dans le mode de rétention, par exemple 1 V. Le potentiel électrique appliqué sur les lignes de bits d'écriture 202 est élevé (par exemple égal à 1,5 V) ou abaissé (par exemple égal à 0 V) selon des valeurs à écrire (bit logique « 1 » ou « 0 », respectivement). La valeur des potentiels électriques appliqués sur toutes les lignes de bits de lecture est égale à 0 V.

Pour chaque verrou mémoire 200 appartenant à la rangée écrite de verrous et dans lequel un bit logique est de « 1 », des hautes valeurs des potentiels électriques appliquées sur la ligne de bits d'écriture 202 et la ligne de mots 116 élèvent le verrou 200 par un courant direct (I_{ON}) dans le premier TFET 102. Une impulsion d'écriture avec ΔV positif (par exemple une impulsion entre 0,5 V et 1,5 V) est appliquée sur la ligne de masse virtuelle 112 de la rangée de verrous, cette impulsion d'écriture formant un signal de sélection de mot. Les potentiels électriques appliqués sur les lignes de masse virtuelle de l'autre rangée de verrous 200 ont une valeur inchangée, par exemple égale à 0,5 V. En raison d'un couplage hautement capacitif entre la ligne de mots virtuelle 112 et le noeud de stockage 108 dans chaque verrou 200 de la rangée écrite, l'impulsion d'écriture ΔV appliquée sur la ligne de masse virtuelle 112 essaie d'induire un ΔV dans le noeud de stockage 108 (c'est-à-dire ΔV de ^{∼}1 V pour cet exemple).

En conséquence, avec le front montant de l'impulsion d'écriture, le noeud de stockage 108 commencera à se balancer de 1V. Cela aboutit à la valeur attendue de 1V pour des noeuds de stockage stockant un « 0 » logique et pour lesquels la ligne de bits d'écriture est à 0 V. Tous les autres noeuds de stockage écrits commencent à monter jusqu'à ^{∼}1,5V, y compris les noeuds de stockage ayant des lignes de bits d'écriture à l'état haut et/ou stockant « 1 ». Avec un noeud de stockage 108 montant à plus de 1 V avec une ligne de bits d'écriture 202 à 0 V, le premier TFET 102 est polarisé en inverse dans la région III (se référer à la figure 1) et déchargera le noeud de stockage 108 et diminuera la tension V_{DS} sur le premier TFET 102 par émission thermoionique. Cela aboutit à limiter la tension sur le noeud de stockage 108. Contrairement au verrou ayant la ligne de bits d'écriture 202 à 0 V, la décharge est minimale (due à I_{OFF}) pour des verrous ayant des lignes de bits de mots à 1,5 V. Cela aboutit à une différence de tension sur des noeuds de stockage 108 entre des valeurs logiques écrites de « 0 » et « 1 ». Après avoir fini l'écriture, la ligne de bits d'écriture 202 est abaissée et un front descendant de l'impulsion d'écriture sur la ligne de masse virtuelle 112 amène le noeud de stockage à 0 V et 0,5V pour des verrous qui avaient une ligne de bits d'écriture à 0 V et 1,5 V, respectivement.

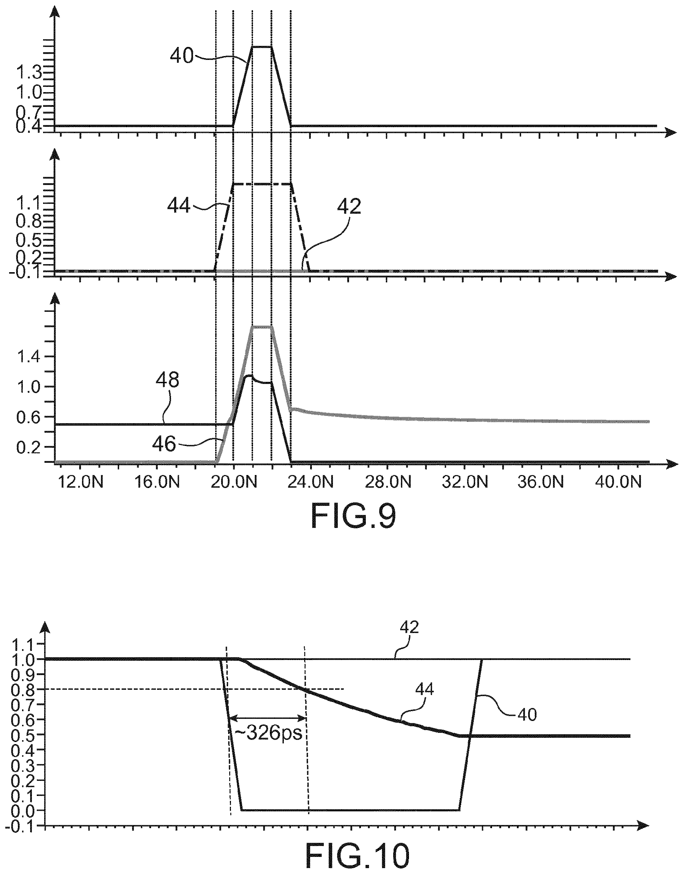

Des formes d'onde d'écriture obtenues pour cette opération d'écriture sont montrées sur la figure 9. La référence 40 désigne le signal appliqué sur la ligne de masse virtuelle 112, dont l'impulsion d'écriture. La référence 42 désigne le signal appliqué sur la ligne de bits d'écriture 202 pendant une écriture de « 0 », et la référence 44 désigne le signal appliqué sur la ligne de bits d'écriture 202 pendant une écriture de « 1 ». La référence 46 désigne le potentiel électrique obtenu dans le noeud de stockage 108 pendant une écriture de « 1 », avec « 0 » initialement stocké dans le noeud de stockage 108. La référence 48 désigne le potentiel électrique obtenu dans le noeud de stockage 108 pendant une écriture de « 0 », avec « 1 » initialement stocké dans le noeud de stockage 108.

A la fin de l'opération d'écriture, une ligne de mots et une ligne de bits d'écriture reviennent aux potentiels électriques de rétention correspondants.

Une opération de lecture est réalisée en utilisant la ligne de bits de lecture 206 et la ligne de mots 116. La ligne de mots 116 connectée à la rangée de verrous mémoire 200 destinée à être lue est abaissée (par exemple 0 V). Toutes les lignes de bits de lecture 206 sont pré-chargées à 1 V, et les potentiels électriques appliqués sur toutes les lignes de bits d'écriture 202 sont ici égaux à 0 V.

Avec la ligne de mots 116 abaissée, le second TFET 204 dans chaque verrou mémoire lu 200 est rendu conducteur ou bloqué selon que la valeur dans le verrou est de « 1 » ou « 0 », respectivement. Pendant la lecture d'un bit « 0 », le potentiel électrique de la ligne de bits de lecture 206 connectée au verrou lu 200 reste sur la valeur pré-chargée de 1 V. Pendant la lecture d'un bit « 1 », le potentiel électrique de la ligne de bits de lecture 206 connectée au verrou de lecture 200 se décharge. Cette différence entre les valeurs obtenues sur la ligne de bits de lecture 206 selon la valeur du bit stocké permet d'identifier la valeur du bit stocké.

Des formes d'onde obtenues pendant la lecture d'un bit « 0 » et d'un bit « 1 » dans le verrou mémoire 200 sont montrées sur la figure 10. La référence 40 désigne le signal appliqué sur la ligne de mots 116 de la rangée de verrous 200 à lire. Les références 42 et 44 désignent les tensions obtenues sur la ligne de bits de lecture 206 pendant une opération de lecture d'un verrou dans lequel un « 0 » et un « 1 » sont stockés, respectivement.

Les verrous mémoire 200 peuvent être flottants pendant des opérations d'écriture, en conséquence, la valeur de capacité des condensateurs 104 peut être adaptée selon la marge de stabilité requise pendant une opération de lecture et d'écriture. La valeur des condensateurs 104 est par exemple égale à la valeur de capacité de la ligne de bits de lecture 206. Pendant des opérations d'écriture, les rangées non sélectionnées de verrous ont des noeuds de stockage flottants en raison de l'état bloqué du premier TFET 102 dans ces verrous à cause de la valeur stockée de 0 V ou 0,5 V. Une fois l'opération de lecture finie, le 0 V (« 0 » logique) est rétabli par le premier TFET 102, alors que la valeur d'un bit logique « 1 » est toujours stable, c'est-à-dire de 0,5 V, en raison d'un courant de fuite obtenu à travers le condensateur 104.

Contrairement au verrou mémoire 100, l'opération de lecture réalisée dans le verrou mémoire 200 ne détruit pas les bits logiques « 0 » stockés. Aucune opération d'écriture différée n'est requise.

Les valeurs des potentiels électriques appliqués au cours des opérations de rétention, d'écriture et de lecture dans le verrou 200 peuvent être différentes de celles données ci-dessus.

De façon similaire à la mémoire DRAM divulguée précédemment formée par plusieurs réseaux 1000 de verrous mémoire 100, une mémoire SRAM peut être mise en oeuvre avec plusieurs réseaux 2000 de verrous mémoire 200. Une telle mémoire peut comprendre plusieurs sous-blocs mis en oeuvre en utilisant les réseaux de verrous. Les lignes de bits de lecture, lignes de bits d'écriture, lignes de mots et lignes de masse virtuelle sont propres à chaque sous-bloc qui peut avoir une sortie multiplexée.

Les verrous mémoire 200 peuvent être conçus avec des TFET planaires dans un procédé CMOS FDSOI de 28 nm avec des condensateurs MIM. La ligne de bits de lecture 206, la ligne de bits d'écriture 202, la ligne de masse virtuelle 112 et la ligne de mots 116 peuvent être réalisées dans un niveau de métal agencé au-dessus de la zone active des TFET du verrou 200.

Contrairement à l'importante EOT des condensateurs qui est utilisée pour réduire la fuite, les verrous mémoire 100, 200 proposés utilisent une EOT plus fine qui aboutit à une surface réduite et à une fuite plus élevée dans le condensateur 104.

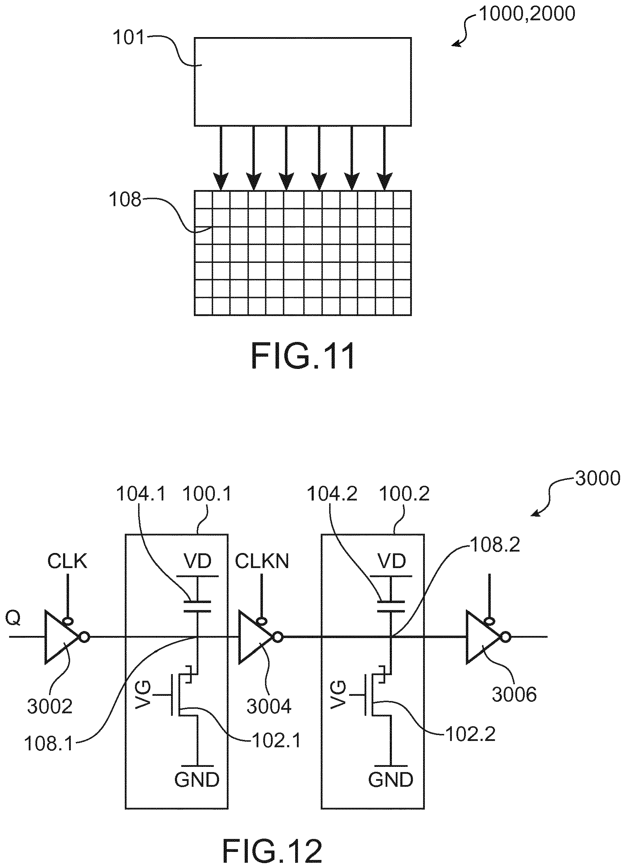

La figure 12 montre une bascule bistable 3000 mise en oeuvre avec deux verrous mémoire 100.1, 100.2 similaires au verrou 100 divulgué précédemment.

La bascule bistable 3000 comprend un premier inverseur synchrone 3002 dont l'entrée forme l'entrée de la bascule bistable 3000. La sortie de l'inverseur 3002 est connectée au noeud de stockage 108.1 du premier verrou mémoire 100.1. Le noeud de stockage 108.1 est également connecté à l'entrée d'un deuxième inverseur synchrone 3004. La sortie du deuxième inverseur synchrone 3004 est connectée au noeud de stockage 108.2 du second verrou mémoire 100.2 qui forme la sortie de la bascule bistable 3000. Dans la configuration montrée sur la figure 12, le noeud de stockage 108.2 est connecté à l'entrée d'un troisième inverseur 1006 optionnel dont la sortie forme dans ce cas la sortie de la bascule bistable 3000.

Le comportement des verrous mémoire 100.1, 100.2 est similaire à celui précédemment divulgué pour le verrou mémoire 100 grâce aux potentiels électriques VD, GND et VD appliqués sur ces verrous 100.1, 100.2.

La synchronisation des signaux à l'intérieur de la bascule bistable 3000 est obtenue grâce au signal d'horloge CLK appliqué sur l'entrée d'horloge du premier inverseur synchrone 3002 et au signal d'horloge complémentaire CLKN (ayant une valeur opposée à celle du signal d'horloge CLK) appliqué sur l'entrée d'horloge du deuxième inverseur synchrone 3004.

La figure 11 montre schématiquement un réseau 1000 ou 2000, et également le circuit de commande 101 couplé électriquement aux différents éléments (TFET 102, 204, condensateur 104) des verrous 100, 200 de ce réseau qui forment une matrice de noeuds de stockage 108. Les flèches montrées sur cette figure représentent les connexions électriques entre le circuit de commande 101 et les différentes lignes des réseaux de verrous à travers lesquels les potentiels électriques sont envoyés.

Le circuit de commande 101 peut également être électriquement couplé aux éléments des verrous 100.1 et 100.2 de la bascule bistable 3000 pour appliquer les potentiels électriques sur les éléments de ces verrous et les signaux CLK et CLKN sur les inverseurs 3002, 3004.

Dans la description ci-dessus, tous les TFET utilisés sont de type n, ou n-TFET. Toutefois, les verrous 100, 200 peuvent être mis en oeuvre en utilisant un TFET de type p, ou p-TFET. Dans ce cas, les électrodes du p-TFET connectées aux autres éléments (lignes, condensateur 104) du verrou sont choisies pour que le comportement de ce verrou soit similaire au comportement décrit ci-dessus. Par exemple, pour le verrou 100 précédemment décrit, si le premier TFET 102 est un p-TFET, la source de ce p-TFET est connectée à la ligne de bits 114 et le drain du p-TFET est connecté au noeud de stockage 108. Lorsque des p-TFET sont utilisés, la valeur des différents potentiels électriques appliqués est également adaptée afin de garder le comportement préalablement décrit du verrou. Le verrou 200 peut être mis en oeuvre en utilisant un n-TFET et/ou un p-TFET.

A titre de variante, selon une deuxième configuration, il est également possible que les verrous 100, 200 soient mis en oeuvre pour que l'électrode du premier TFET 102 connecté au noeud de stockage 108 corresponde au drain du premier TFET 102 lorsque le premier TFET 102 est un TFET de type n ou à la source du premier TFET 102 lorsque le premier TFET 102 est un TFET de type p.

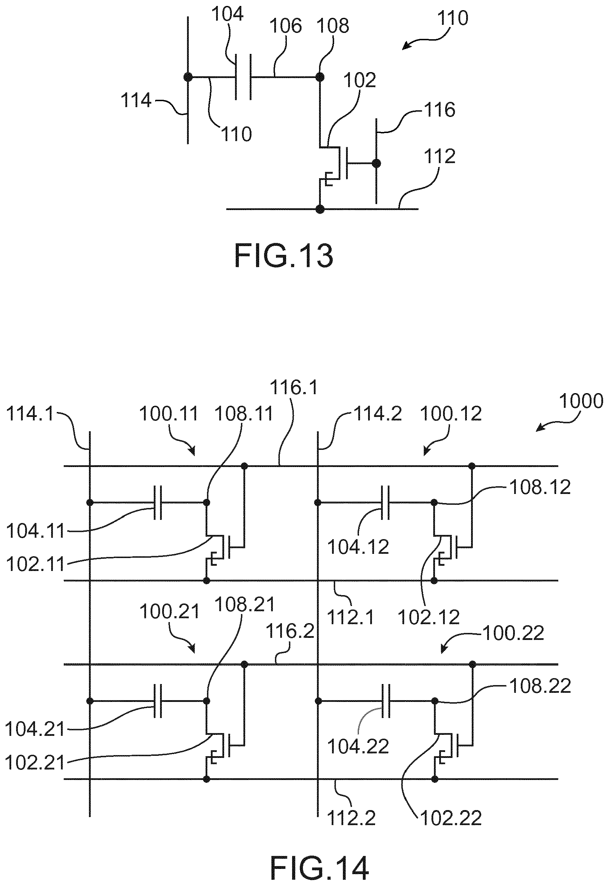

La figure 13 représente un tel verrou 100 selon cette deuxième configuration.

Le verrou 100 comprend le TFET 102, de type n, et le condensateur 104. Le drain du TFET 102 est connecté à la première borne 106 du condensateur 104, cette connexion formant le noeud de stockage 108 du verrou 100. La seconde borne 110 du condensateur 104 est connectée à la ligne de bits 114, la source du TFET 102 est connectée à la ligne de masse virtuelle 112, et la grille du TFET 102 est connectée à la ligne de mots 116. Le verrou 100 comprend également le circuit de commande 101, non visible sur la figure 13.

Un exemple d'un réseau de verrous DRAM 1000 est montré sur la figure 14. Le réseau de verrous 1000 comprend n rangées et m colonnes de n x m verrous 100.11 à 100.nm. Sur la figure 14, seuls quatre verrous 100, référencés 100.11 à 100.22, sont montrés. Des mots de données sont ici stockés horizontalement, chacun dans une rangée de verrous 100.

Chaque ligne de mots 116 est connectée aux verrous 100 agencés sur la même rangée du réseau 1000. La ligne de mots référencée 116.x est ainsi connectée aux grilles des TFET 102.x1 à 102.xm appartenant à la x^{ième} rangée du réseau 1000. Sur la figure 14, seules deux lignes de mots 116.1 (connectée aux grilles des TFET 102.11 et 102.12) et 116.2 (connectée aux grilles des TFET 102.21 et 102.22) sont montrées. De manière similaire aux lignes de mots 116, chaque ligne de masse virtuelle 112 est connectée aux verrous 100 agencés sur la même rangée du réseau. Sur la figure 14, seules deux lignes de masse virtuelle 112.1 (connectée aux sources des TFET 102.11 et 102.12) et 112.2 (connectée aux sources des TFET 102.21 et 102.22) sont montrées.

Chaque ligne de bits 114 est acheminée verticalement, c'est-à-dire connectée à tous les verrous 100 agencés dans une même colonne du réseau 1000. Sur la figure 14, seules deux lignes de bits 114.1 (connectée aux condensateurs 104.11 et 104.21) et 114.2 (connectée aux condensateurs 104.12 et 104.22) sont montrées.

Comme dans la première configuration, les éléments du verrou mémoire 100 sont conçus pour que pendant un mode de rétention, ou mode de stockage, du verrou 100, à savoir lorsqu'une valeur d'un bit est mémorisée et gardée dans le verrou mémoire 100, I_{OFF} (courant de blocage du TFET 102) << I_{LEAKCap} (courant de fuite du condensateur 104) << I_{HUMP} (courant de bosse du TFET 102, correspondant au courant I_{D} dans la région I montrée sur la figure 1). Par exemple, la valeur du rapport I_{HUMP}/I_{LEAKCap} peut être d'environ 10³, et la valeur du rapport I_{LEAKcCap}/I_{OFF} peut être d'environ 10³. Plus généralement, ces courants peuvent être tels que I_{OFF} < I_{LEAKCap} < I_{HUMP}.

Dans ce cas, les valeurs des potentiels électriques appliqués sur le premier TFET 102 et du condensateur 104 du verrou 100, 200 sont adaptées pour avoir un comportement du verrou similaire à celui décrit ci-dessus. Par exemple, pendant une rétention d'un bit dans le verrou, les potentiels électriques appliqués sur le verrou 100, 200 sont choisis pour que :
- lorsque la valeur du potentiel électrique du noeud de stockage 108 est haute, le premier TFET 102 soit polarisé en inverse dans un état dans lequel un courant de conduction est obtenu par effet tunnel de bande à bande dans le premier TFET 102 avec une valeur plus élevée qu'un courant de fuite du condensateur 104 ;
- lorsque la valeur du potentiel électrique du noeud de stockage 108 est basse, le premier TFET 102 soit polarisé en inverse avec un courant de blocage obtenu dans le premier TFET 102 avec une valeur inférieure au courant de fuite du condensateur 104.

Par exemple, lors d'une phase de rétention, un potentiel égal à 0 V peut être appliqué sur la ligne de bit 114, un potentiel égal à 0,5 V peut être appliqué sur la ligne de masse virtuelle 112, et un potentiel égal à 1 V peut être appliqué sur la ligne de mots 116.

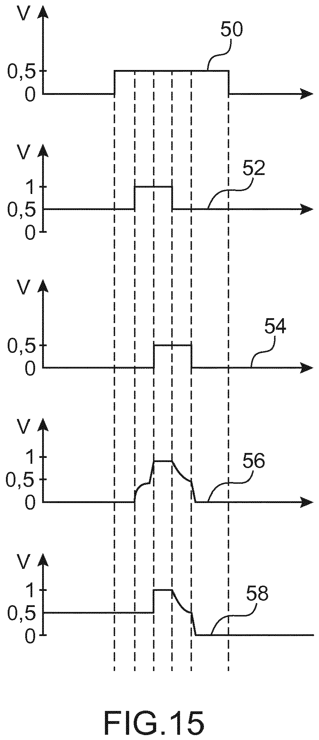

Les courbes représentées sur la figure 15 correspondent à des exemples de potentiels électriques appliqués lors d'une phase d'écriture d'un potentiel électrique de valeur basse, ici 0 V, dans le noeud de stockage 108 du verrou 100 précédemment décrit en lien avec les figures 13 et 14. Sur cette figure, la référence 50 désigne le potentiel électrique sur la ligne de mots 116, la référence 52 désigne le potentiel électrique sur la ligne de masse virtuelle 112, la référence 54 désigne le potentiel électrique sur la ligne de bits 114, la référence 56 désigne le potentiel électrique sur le noeud de stockage 108 lorsque la valeur initialement stockée correspond à la valeur basse, et la référence 58 désigne le potentiel électrique sur le noeud de stockage 108 lorsque la valeur initialement stockée correspond à la valeur haute, par exemple égale à 0,5 V.

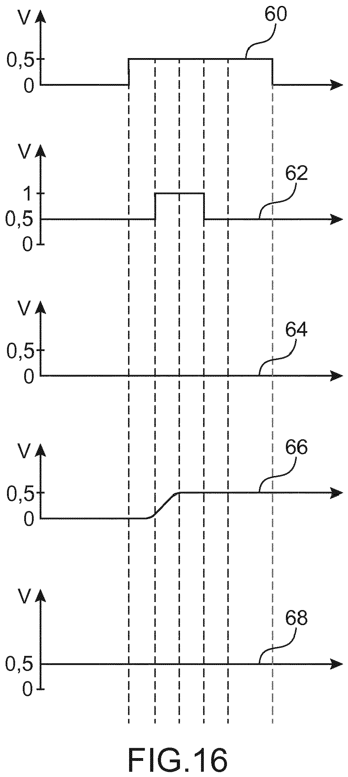

Les courbes représentées sur la figure 16 correspondent à des exemples de potentiels électriques appliqués lors d'une phase d'écriture d'un potentiel électrique de valeur haute, ici 0,5 V, dans le noeud de stockage 108 du verrou 100 précédemment décrit en lien avec les figures 13 et 14. Sur cette figure, la référence 60 désigne le potentiel électrique sur la ligne de mots 116, la référence 62 désigne le potentiel électrique sur la ligne de masse virtuelle 112, la référence 64 désigne le potentiel électrique sur la ligne de bits 114, la référence 66 désigne le potentiel électrique sur le noeud de stockage 108 lorsque la valeur initialement stockée correspond à la valeur basse, et la référence 68 désigne le potentiel électrique sur le noeud de stockage 108 lorsque la valeur initialement stockée correspond à la valeur haute.

Une opération de lecture réalisée sur le verrou 100 selon la deuxième configuration est similaire à celle réalisée sur le verrou 100 selon la première configuration. Toutefois, il convient de noter que lors d'une opération de lecture réalisée sur le verrou 100 selon la deuxième configuration, c'est le potentiel électrique obtenu sur la ligne de masse virtuelle 112 qui est lue et non celui sur la ligne de bits 114 comme c'est le cas dans la première configuration. Ainsi, dans un réseau de verrous DRAM 1000 tel que celui représenté sur la figure 14, une lecture par ligne réalise une lecture de l'ensemble des valeurs des verrous présents sur la ligne lue, ce qui peut par exemple servir à connaître une valeur moyenne des valeurs stockées dans les verrous présents sur la ligne lue. Pour réaliser une lecture individuelle des verrous, les verrous sont dans ce cas réalisés en ajoutant un second TFET 204, comme dans le verrou 200 précédemment décrit en lien avec les figures 7 et 8. Dans ce cas, la deuxième borne 110 du condensateur 104 est reliée à une ligne de bits d'écriture 202, la grille du second TFET 204 est reliée au noeud de stockage 108, la source du second TFET 204 est reliée à la ligne de mots 116 et le drain du second TFET 204 est relié à une ligne de bits de lecture 206.

En outre, comme pour la première configuration, le TFET 102 (et/ou le TFET 204 pour le verrou 200) peut être de type p. Dans ce cas, les électrodes du p-TFET connectées aux autres éléments (lignes, condensateur 104) du verrou sont choisies pour que le comportement de ce verrou soit similaire au comportement décrit ci-dessus. Par exemple, pour le verrou 100 précédemment décrit en lien avec la figure 13, si le premier TFET 102 est un p-TFET, la source de ce p-TFET est connectée au noeud de stockage 108 et le drain du p-TFET est connecté à la ligne de masse virtuelle 112.

Dans les verrous 100, 200, les valeurs des potentiels électriques utilisés pour les opérations de rétention, d'écriture et de lecture peuvent être différentes des exemples divulgués précédemment. En particulier, ces valeurs sont adaptées selon les particularités et performances souhaitées du verrou.

Avec les verrous 100, 200, plusieurs opérations de lecture et/ou d'écriture peuvent être réalisées successivement, sans retour en mode de rétention entre chacune de ces opérations. Toutefois, du fait que la mémoire comprenant les verrous 100, 200 est généralement plus rapide que les autres éléments électroniques fonctionnant avec cette mémoire, il est avantageux que le circuit de commande 101 mette les verrous 100, 200 dans le mode de rétention entre chaque opération de lecture et/ou d'écriture.

## Revendications

1. Verrou mémoire (100, 200) comprenant au moins :
- un premier transistor à effet de champ tunnel, TFET (102) ;
- un condensateur (104) ;
- un noeud de stockage (108) formé par la connexion d'une première borne (106) du condensateur (104) à une première électrode du premier TFET (102) correspondant à la source ou au drain du premier TFET (102) et configuré pour stocker un bit tel que des valeurs basse et haute du potentiel électrique du noeud de stockage (108) soient représentatives de la valeur du bit stocké ;
- un circuit de commande (101) configuré pour fournir un premier potentiel électrique sur une ligne de masse virtuelle (112), un deuxième potentiel électrique sur une ligne de mots (116) connectée à la grille du premier TFET (102) et un troisième potentiel électrique sur une ligne de bits (114, 202) ;
dans lequel :
- dans une première configuration, une seconde borne (110) du condensateur (104) est connectée à la ligne de masse virtuelle (112), la première électrode du premier TFET (102) correspond à sa source lorsque le premier TFET (102) est de type n ou à son drain lorsque le premier TFET (102) est de type p, une seconde électrode du premier TFET (102), correspondant à son drain lorsque la première électrode correspond à la source ou à sa source lorsque la première électrode correspond au drain, est connectée à la ligne de bits (114, 202), ou
- dans une deuxième configuration, une seconde borne (110) du condensateur (104) est connectée à la ligne de bits (114, 202), la première électrode du premier TFET (102) correspond à son drain lorsque le premier TFET (102) est de type n ou à sa source lorsque le premier TFET (102) est de type p, une seconde électrode du premier TFET (102), correspondant à sa source lorsque la première électrode correspond au drain ou à son drain lorsque la première électrode correspond à la source, est connectée à la ligne de bits (114, 202) ;
et dans lequel le circuit de commande (101) est configuré pour fournir, pendant une rétention d'un bit stocké dans le noeud de stockage (108), les premier, deuxième et troisième potentiels électriques avec des valeurs telles que :
- lorsque le bit stocké a une première valeur, une première tension de polarisation appliquée entre la source et le drain du premier TFET (102) a une valeur absolue inférieure à celle d'une deuxième tension de polarisation appliquée entre les première et deuxième bornes du condensateur (104) et polarise en inverse le premier TFET (102) tel qu'un courant de conduction obtenu par effet tunnel de bande à bande dans le premier TFET (102) ait une valeur plus élevée qu'un courant de fuite du condensateur (104) ;
- lorsque le bit stocké a une seconde valeur différente de la première valeur, la première tension de polarisation a une valeur absolue supérieure à celle de la deuxième tension de polarisation et polarise en inverse le premier TFET (102) tel qu'un courant de blocage obtenu dans le premier TFET (102) ait une valeur plus faible que le courant de fuite du condensateur (104).

2. Verrou mémoire (100, 200) selon la revendication 1, dans lequel le circuit de commande (101) est configuré pour fournir les premier, deuxième et troisième potentiels électriques avec des valeurs telles que :
- dans la première configuration, lorsque la valeur du potentiel électrique du noeud de stockage (108) est basse, la première tension de polarisation polarise en inverse le premier TFET tel que le courant de conduction obtenu par effet tunnel de bande à bande dans le premier TFET (102) ait une valeur plus élevée que le courant de fuite du condensateur (104) ;
- dans la première configuration, lorsque la valeur du potentiel électrique du noeud de stockage (108) est haute, la première tension de polarisation polarise en inverse le premier TFET (102) tel que le courant de blocage obtenu dans le premier TFET (102) ait une valeur plus faible que le courant de fuite du condensateur (104) ;
- dans la deuxième configuration, lorsque la valeur du potentiel électrique du noeud de stockage (108) est basse, la première tension de polarisation polarise en inverse le premier TFET (102) tel que le courant de blocage obtenu dans le premier TFET (102) ait une valeur plus faible que le courant de fuite du condensateur (104) ;
- dans la deuxième configuration, lorsque la valeur du potentiel électrique du noeud de stockage (108) est haute, la première tension de polarisation polarise en inverse le premier TFET (102) tel que le courant de conduction obtenu par effet tunnel de bande à bande dans le premier TFET (102) ait une valeur plus élevée que le courant de fuite du condensateur (104).

3. Verrou mémoire (100, 200) selon l'une des revendications précédentes, dans lequel le circuit de commande (101) est configuré pour fournir, pendant la rétention d'un bit stocké dans le noeud de stockage (108), les premier, deuxième et troisième potentiels électriques de telle sorte que la valeur absolue du premier potentiel électrique soit supérieure à la valeur absolue du troisième potentiel électrique, et que la valeur absolue du deuxième potentiel électrique soit supérieure à la valeur absolue du premier potentiel électrique.

4. Verrou mémoire (100, 200) selon l'une des revendications précédentes, dans lequel le circuit de commande (101) est configuré pour fournir, pendant la rétention d'un bit stocké dans le noeud de stockage (108), les premier, deuxième et troisième potentiels électriques de telle sorte que la valeur absolue du premier potentiel électrique soit sensiblement égale à la valeur haute du potentiel électrique du noeud de stockage (108), et/ou que la valeur absolue du troisième potentiel électrique soit sensiblement égale à la valeur basse du potentiel électrique du noeud de stockage (108).

5. Verrou mémoire (100, 200) selon l'une des revendications précédentes, dans lequel le circuit de commande (101) est configuré pour fournir, pendant une écriture d'un bit dans le noeud de stockage (108), les premier, deuxième et troisième potentiels électriques de telle sorte que :
- le premier potentiel électrique inclut une impulsion d'écriture déclenchant l'écriture du bit dans le noeud de stockage (108), et la valeur du troisième potentiel électrique est représentative de la valeur du bit à écrire pendant au moins une partie de l'impulsion d'écriture ;
- lorsque la valeur du bit à écrire correspond à la valeur basse du potentiel électrique du noeud de stockage, le premier TFET (102) est polarisé en inverse dans un état dans lequel un courant de conduction est obtenu par émission thermoionique sur la barrière formée dans le premier TFET (102) pendant l'impulsion d'écriture, déchargeant le noeud de stockage (108) par le biais du premier TFET (102) ;
- lorsque la valeur du bit à écrire correspond à la valeur haute du potentiel électrique du noeud de stockage, le premier TFET (102) est polarisé en direct.

6. Verrou mémoire (100, 200) selon la revendication 5, dans lequel :
- pendant l'écriture d'un bit correspondant à la valeur basse du potentiel électrique du noeud de stockage (108), la valeur absolue du deuxième potentiel électrique est supérieure ou égale à la valeur absolue du troisième potentiel électrique, la valeur absolue du premier potentiel électrique pendant l'impulsion d'écriture est égale ou supérieure à la valeur absolue du deuxième potentiel électrique, et
- pendant l'écriture d'un bit correspondant à la valeur haute du potentiel électrique du noeud de stockage (108), la valeur absolue du troisième potentiel électrique est égale ou supérieure à la valeur absolue du deuxième potentiel électrique, et la valeur absolue du premier potentiel électrique pendant l'impulsion d'écriture est égale ou supérieure à la valeur absolue du deuxième potentiel électrique.

7. Verrou mémoire (100) selon l'une des revendications précédentes, dans lequel le circuit de commande (101) est configuré pour appliquer, pendant une lecture d'un bit stocké dans le noeud de stockage (108), un potentiel électrique de pré-charge sur la ligne de bits (114) puis une tension d'impulsion sur la grille du premier TFET (102) de telle sorte que la valeur du potentiel électrique sur la ligne de bits (114) baisse pendant l'impulsion seulement si la valeur du potentiel électrique du noeud de stockage est basse.

8. Verrou mémoire (100, 200) selon l'une des revendications 1 à 6, comprenant en outre :
- un second TFET (204) ayant sa grille connectée au noeud de stockage (108), et une première électrode, correspondant à sa source lorsque le second TFET (204) est de type n ou à son drain lorsque le second TFET (204) est de type p, reliée à la ligne de mots (116),
- une ligne de bits de lecture (206) connectée à une seconde électrode du second TFET (204), correspondant à son drain lorsque la première électrode correspond à sa source ou à sa source lorsque la première électrode correspond à son drain,
et dans lequel le circuit de commande (101) est configuré pour appliquer, pendant une lecture d'un bit stocké dans le noeud de stockage (108), une impulsion de lecture sur la ligne de mots (116) de telle sorte que la valeur d'un potentiel électrique sur la ligne de bits de lecture (206) baisse pendant l'impulsion seulement si la valeur du potentiel électrique du noeud de stockage est haute.

9. Réseau de verrous DRAM (1000) comprenant plusieurs verrous mémoire (100) selon l'une des revendications 1 à 7 et agencés selon un réseau de plusieurs rangées et plusieurs colonnes, et dans lequel :
- chaque ligne de mots (116) est connectée à la grille du premier TFET (102) de chacun des verrous mémoire (100) appartenant à une même rangée du réseau ;
- chaque ligne de masse virtuelle (112) est connectée à chacun des verrous mémoire (100) appartenant à une même rangée du réseau ;
- chaque ligne de bits (114) est connectée à chacun des verrous mémoire (100) appartenant à une même colonne du réseau ;
- le circuit de commande (101) est commun à tous les verrous mémoire (100) du réseau de verrous DRAM (1000) et configuré pour fournir les potentiels électriques auxdits verrous mémoire (100) par le biais des lignes de bits (114), des lignes de mots (116) et des lignes de masse virtuelle (112).

10. Réseau de verrous DRAM (1000) selon la revendication 9, dans lequel le circuit de commande (101) est configuré pour réaliser une opération d'écriture collectivement pour une rangée de verrous mémoire (100) du réseau de telle sorte que :
- la valeur absolue d'un potentiel électrique appliqué sur la ligne de mots (116) connectée aux verrous mémoire (100) de ladite une rangée de verrous mémoire (100) soit supérieure à la valeur absolue d'un potentiel électrique appliqué sur les lignes de mots (116) connectées aux autres verrous mémoire (100), puis
- les valeurs absolues des potentiels électriques appliqués sur toutes les lignes de bits (114) soient fixées selon les valeurs de bits à écrire dans ladite une rangée de verrous mémoire (100), puis
- une impulsion d'écriture soit appliquée sur la ligne de masse virtuelle (112) connectée aux verrous mémoire (100) de ladite une rangée de verrous mémoire (100).

11. Réseau de verrous DRAM (1000) selon l'une des revendications 9 et 10, dans lequel le circuit de commande (101) est configuré pour réaliser une opération de lecture collectivement pour une rangée de verrous mémoire (100) du réseau de telle sorte que :
- la valeur absolue des potentiels électriques appliqués sur toutes les lignes de mots (116) soit basse, puis
- des potentiels électriques de pré-charge soient appliqués sur toutes les lignes de bits (114), puis
- une impulsion de lecture soit appliquée sur la ligne de mots (116) connectée aux verrous mémoire (100) de ladite une rangée de verrous mémoire (100).

12. Réseau de verrous SRAM (2000), comprenant plusieurs verrous mémoire (200) selon la revendication 8 et agencés selon un réseau de plusieurs rangées et plusieurs colonnes, et dans lequel :
- chaque ligne de mots (116) est connectée à la grille du premier TFET (102) et à la première électrode du second TFET (204) de chacun des verrous mémoire (200) appartenant à une même rangée du réseau ;
- chaque ligne de masse virtuelle (112) est connectée à chacun des verrous mémoire (100) appartenant à une même rangée du réseau ;
- chaque ligne de bits de lecture (206) et chaque ligne de bits, appelée ligne de bits d'écriture (202), sont connectées à chacun des verrous mémoire (200) appartenant à une même colonne du réseau ;
- le circuit de commande (101) est commun à tous les verrous mémoire (200) du réseau de verrous SRAM (2000) et configuré pour apporter les potentiels électriques auxdits verrous mémoire (200) par le biais des lignes de bits de lecture (206), des lignes de bits d'écriture (202), des lignes de mots (116) et des lignes de masse virtuelle (112).

13. Réseau de verrous SRAM (2000) selon la revendication 12, dans lequel le circuit de commande (101) est configuré pour réaliser une opération d'écriture collectivement pour une rangée de verrous mémoire (200) du réseau de telle sorte que :
- la valeur absolue d'un potentiel électrique appliqué sur la ligne de mots (116) connectée aux verrous mémoire (200) de ladite une rangée de verrous mémoire (200) soit supérieure à la valeur absolue d'un potentiel électrique appliqué sur les lignes de mots (116) connectées aux autres verrous mémoire (200), puis
- les valeurs absolues des potentiels électriques appliqués sur toutes les lignes de bits d'écriture (202) soient fixées selon les valeurs de bits à écrire dans ladite une rangée de verrous mémoire (200), puis
- une impulsion d'écriture soit appliquée sur la ligne de masse virtuelle (112) connectée aux verrous mémoire (200) de ladite une rangée de verrous mémoire (200).

14. Réseau de verrous SRAM (2000) selon l'une des revendications 12 et 13, dans lequel le circuit de commande (101) est configuré pour réaliser une opération de lecture collectivement pour une rangée de verrous mémoire (200) du réseau de telle sorte que :
- la valeur absolue des potentiels électriques appliqués sur toutes les lignes de mots (116) soit haute, puis
- une impulsion de lecture soit appliquée sur la ligne de mots (116) connectée aux verrous mémoire (200) de ladite une rangée de verrous mémoire (200).

15. Bascule bistable (3000) comprenant au moins :
- des premier et second verrous mémoire (100.1, 100.2) selon l'une des revendications précédentes 1 à 7 ;
- un premier inverseur ayant une entrée formant l'entrée de la bascule bistable (3000) et une sortie connectée au noeud de stockage (108.1) du premier verrou (100.1) ;
- un second inverseur ayant une entrée connectée au noeud de stockage (108.1) du premier verrou (100.1) et une sortie connectée au noeud de stockage (108.2) du second verrou (100.2).
